# EUROPEAN PATENT APPLICATION

(11) **EP 4 604 145 A1**
(43) Date of publication of application: **20.08.2025**
(21) Application number: 25154466.4
(22) Date of filing: 28.01.2025
(51) Int. Cl.: H01F 27/00, H01F 27/28, H01F 27/29, H01F 27/40, H05K 1/14, H01F 19/00, H01F 3/14

(54) **ELECTRICAL ASSEMBLIES INCLUDING MAGNETIC DEVICES**

(30) Priority: 19.02.2024 US 202418581120
(71) Applicant: Analog Devices, Inc., Wilmington, MA 01887 (US)
(72) Inventor: Paduvalli, Vikas, Limerick (IE); Ikriannikov, Alexandr, Limerick (IE)
(74) Representative: Horler, Philip John

(57) **Abstract**

An electrical assembly includes a first substrate, a second substrate, and a magnetic device disposed between the first substrate and the second substrate. The magnetic device includes (1) a magnetic core, (2) a first primary winding extending through the magnetic core and electrically coupling the first substrate to the second substrate, (3) a second primary winding extending through the magnetic core and electrically coupling the first substrate to the second substrate, (4) a first secondary winding wound around at least a portion of the magnetic core, and (5) a second secondary winding wound around at least a portion of the magnetic core. The electrical assembly further includes one or more electrical conductors on the first substrate electrically coupling the first secondary winding in series with the second secondary winding.

## Description

### BACKGROUND

Switching power converters are widely used in electronic devices, such as to provide a regulated electric power source. A switching power converter is configured such that its solid-state power switching devices do not continuously operate in their active states; instead, the power switching devices repeatedly switch between their on-states and off-states. Switching power converters commonly include one or more inductors for energy storage.

### BRIEF DESCRIPTION OF THE DRAWINGS

FIG. 1 is a schematic diagram of an electrical assembly including a magnetic device, according to an embodiment.
FIG. 2 is a top plan view of a magnetic device, according to an embodiment.
FIG. 3 is a front elevational view of the FIG. 2 magnetic device.
FIG. 4 is a bottom plan view of the FIG. 2 magnetic device.
FIG. 5 is a side elevational view of the FIG. 2 magnetic device.
FIG. 6 is a cross-sectional view of the FIG. 2 magnetic device taken along line 6A-6A of FIG. 2.
FIG. 7 is a top plan view of an embodiment of the FIG. 2 magnetic device where a magnetic core forms two gaps.
FIG. 8 is a top plan view of another embodiment of the FIG. 2 magnetic device where a magnetic core forms two gaps.
FIG. 9 is a front elevational view of an electrical assembly including an instance of the FIG. 2 magnetic device, according to an embodiment.
FIG. 10 is a side elevational view of the FIG. 9 electrical assembly.
FIG. 11 is top plan view of the FIG. 9 electrical assembly.
FIG. 12 is an electrical schematic diagram of a multi-phase switching power converter at least partially formed by elements of the FIG. 9 electrical assembly.
FIG. 13 is a front elevational view of an alternate embodiment of the FIG. 9 electrical assembly.
FIG. 14 is a side elevational view of the FIG. 13 electrical assembly.
FIG. 15 is top plan view of the FIG. 13 electrical assembly.
FIG. 16 is a top plan view of an alternate embodiment of the FIG. 2 magnetic device.
FIG. 17 is a front elevational view of the FIG. 16 magnetic device.
FIG. 18 is a side elevational view of the FIG. 16 magnetic device.
FIG. 19 is a bottom plan view of the FIG. 16 magnetic device.
FIG. 20 is a top plan view of an alternate embodiment of the FIG. 16 magnetic device further including ground conductors.
FIG. 21 is a front elevational view of the FIG. 20 magnetic device.
FIG. 22 is a side elevational view of the FIG. 20 magnetic device.
FIG. 23 is a bottom elevational view of the FIG. 20 magnetic device.
FIG. 24 is a cross-sectional view of the FIG. 20 magnetic device taken along line 24A-24A of FIG. 20.
FIG. 25 is a front elevational view of an alternate embodiment of the FIG. 9 electrical assembly including the FIG. 20 magnetic device in place of the FIG. 2 magnetic device.
FIG. 26 is schematic diagram of an alternate embodiment of the FIG. 12 multi-phase switching power converter including the FIG. 20 magnetic device in place of the FIG. 2 magnetic device.
FIG. 27 is a top plan view of another alternate embodiment of the FIG. 16 magnetic device further including ground conductors.
FIG. 28 is a front elevational view of the FIG. 27 magnetic device.
FIG. 29 is a side elevational view of the FIG. 27 magnetic device.
FIG. 30 is a cross-sectional view of the FIG. 27 magnetic device taken along line 30A-30A of FG. 27.
FIG. 31 is a bottom plan view of the FIG. 27 magnetic device.
FIG. 32 is a top plan view of an alternate embodiment of the FIG. 2 magnetic device including two additional winding sets.
FIG. 33 is a front elevational view of the FIG. 32 magnetic device.
FIG. 34 is a side elevational view of the FIG. 32 magnetic device.
FIG. 35 is a bottom plan view of the FIG. 32 magnetic device.
FIG. 36 is a cross-sectional view of the FIG. 32 magnetic device taken along line 36A-36A of FIG. 32.
FIG. 37 is a top plan view of an alternate embodiment of the FIG. 2 magnetic device including only a single winding set.
FIG. 38 is a front elevational view of the FIG. 37 magnetic device.
FIG. 39 is a side elevational view of the FIG. 37 magnetic device.
FIG. 40 is a bottom plan view of the FIG. 37 magnetic device.
FIG. 41 is a front elevational view of an alternate embodiment of the FIG. 9 electrical assembly including two instances of the FIG. 37 magnetic device in place of the FIG. 2 magnetic device.
FIG. 42 is a top plan view of the FIG. 41 electrical assembly.
FIG. 43 is a front elevational view of an alternate embodiment of the FIG. 41 electrical assembly including two substrates in place of a single common substrate.
FIG. 44 is a top plan view of the FIG. 43 electrical assembly.
FIG. 45 is a bottom plan view of the FIG. 43 electrical assembly.
FIG. 46 is an electrical schematic diagram of a multi-phase switching power converter at least partially formed by elements of the FIG. 43 electrical assembly.
FIG. 47 is a top plan view of an alternate embodiment of the FIG. 20 magnetic device with primary windings forming two turns each.
FIG. 48 is a front elevational view of the FIG. 47 magnetic device.
FIG. 49 is a side elevational view of the FIG. 47 magnetic device.
FIG. 50 is a bottom plan view of the FIG. 47 magnetic device.
FIG. 51 is a back elevational view of the FIG. 47 magnetic device.
FIG. 52 is a top plan view of an alternate embodiment of the FIG. 47 magnetic device that is scalable in two directions.
FIG. 53 is a front elevational view of the FIG. 52 magnetic device.
FIG. 54 is a bottom plan view of the FIG. 52 magnetic device.
FIG. 55 is a front elevational view of an alternate embodiment of the FIG. 2 magnetic device where winding ends are offset from magnetic core outer surfaces.
FIG. 56 is a side elevational view of the FIG. 55 magnetic device.
FIG. 57 is a side elevational view of the FIG. 55 magnetic device opposite of the side elevational view of FIG. 56.
FIG. 58 is a front elevational view of an alternate embodiment of the FIG. 9 electrical assembly including the FIG. 55 magnetic device in place of the FIG. 2 magnetic device.
FIG. 59 is a top plan view of an alternate embodiment of the FIG. 2 magnetic device where secondary winding ends terminate on a front outer surface of a magnetic core instead of a top outer surface of the magnetic core.
FIG. 60 is a front elevational view of the FIG. 59 magnetic device.
FIG. 61 is a bottom plan view of the FIG. 59 magnetic device.
FIG. 62 is a side elevational view of the FIG. 59 magnetic device.
FIG. 63 is a front elevational view of an alternate embodiment of the FIG. 9 electrical assembly including the FIG. 59 magnetic device in place of the FIG. 2 magnetic device.
FIG. 64 is a side elevational view of the FIG. 63 electrical assembly.
FIG. 65 is a top plan view of a magnetic device where primary windings terminate on a different surface than secondary windings, according to an embodiment.
FIG. 66 is a front elevational view of the FIG. 65 magnetic device.
FIG. 67 is a bottom plan view of the FIG. 65 magnetic device.
FIG. 68 is a side elevational view of the FIG. 65 magnetic device
FIG. 69 is a side elevational view of the FIG. 65 magnetic device opposite of the FIG. 68 side elevational view.
FIG. 70 is a cross-sectional view of the FIG. 65 magnetic device taken along line 70A-70A of FIG. 65.
FIG. 71 is a front elevational view of an electrical assembly including the FIG. 65 magnetic device, according to an embodiment.
FIG. 72 is a side elevational view of the FIG. 71 electrical assembly.
FIG. 73 is a top plan view of the FIG. 71 electrical assembly.
FIG. 74 is an electrical schematic diagram of a multi-phase switching power converter at least partially formed by elements of the FIG. 71 electrical assembly.

### DETAILED DESCRIPTION OF THE EMBODIMENTS

Some switching power converters include a plurality of phases, where each phase includes a respective switching stage and a respective inductor. Such switching power converters may be referred to as multi-phase switching power converters. While not required, the respective switching stage of each phase typically switches out-of-phase with respect to the respective switching stage of each other phase. The inductors of a multi-phase switching power converter may be magnetically coupled to realize significant benefits, such as lower ripple current magnitude and/or faster transient response, than an otherwise similar multi-phase switching power converter without magnetic coupling of its inductors. Alternately, phases of a multi-phase switching power converter may be electrically coupled by replacing each inductor with a primary winding, magnetically coupled a respective secondary winding with each primary winding, and electrically coupling the secondary windings in series. Such electrical coupling of phases may also lower ripple current magnitude and/or improve transient response, albeit not to the degree that is possible with magnetic coupling of phases. The magnetic coupling of phases can also be combined with electrical coupling of phases; for example, two of four phase magnetically coupled inductors can be electrically coupled to each other.

Electrical assemblies including switching power converters may include more than one substrate, such as more than one printed circuit board (PCB). For example, switching stages of a switching power converter may be located on one substrate, and output capacitors of the switching power converter may be located on a second substrate. The first and second substrates are electrically connected, for example, by metallic pins joining the substrates.

Disclosed herein are electrical assemblies including magnetic devices which significantly advance the state of the art of multi-phase switching power converters with electrical coupling of phases. Particular embodiments include a magnetic device sandwiched between a first substrate and a second substrate, such as between a first and a second PCB. The magnetic device includes a plurality primary windings extending through a magnetic core of the magnetic device, and each primary winding electrically couples the first substrate to the second substrate, such that one end of each primary winding is electrically coupled to the first substrate and an opposing end of the primary winding is electrically coupled to the second substrate. Additionally, the magnetic device includes a respective secondary winding magnetically coupled to each primary winding, and opposing ends of each secondary winding are electrically coupled to the first substrate. The secondary windings are electrically coupled in series by one or more electrical conductors on the first substrate.

Furthermore, some embodiments include a plurality of magnetic devices, where each magnetic device is disposed between a first substrate and a second substrate. Each magnetic device includes a primary winding extending through a magnetic core of the magnetic device and electrically coupling the first substrate to the second substrate. Each magnetic device further includes a secondary winding magnetically coupled to the primary winding of the magnetic device, and opposing ends of the secondary winding are electrically coupled to the first substrate. The secondary windings of the magnetic devices are electrically coupled in series by one or more electrical conductors on the first substrate.

Additionally, certain embodiments include a plurality of magnetic devices, where each magnetic device is disposed between a common substrate and a respective additional substrate. Each magnetic device includes a primary winding extending through a magnetic core of the magnetic and device and electrically coupling the first substrate to the respective additional substrate of the magnetic device. Each magnetic device further includes a secondary winding magnetically coupled to the primary winding of the magnetic device, and opposing ends of the secondary winding are electrically coupled to the first substrate. The secondary windings of the magnetic devices are electrically coupled in series by one or more electrical conductors on the first substrate.

The new electrical assemblies may achieve significant advantages that may not be realized by conventional approaches. For example, in particular embodiments, the primary windings form electrical connections between substrates, thereby reducing, or even eliminating, the need for additional electrical conductors to electrically couple the primary windings to each substrate or additional conductors to pass the current between the substrates, which promotes low electrical resistance in primary winding connections. Low electrical resistance in primary winding connections, in turn, promotes low power loss, low resistive heating, and high efficiency. Additionally, in particular embodiments, the secondary windings terminate on a common plane, e.g., on the surface of a common substrate, which promotes ease of electrical connections to the secondary windings and promotes planarity of the magnetic device on a side of the magnetic device opposite of a side where the secondary windings terminate. Furthermore, some embodiments include standard geometry magnetic core elements that do not need to be redesigned to accommodate the secondary windings, such as two E-cores or an E-core and I-core, which promotes ease of manufacturing, low cost, and ease of sourcing the magnetic core elements. Moreover, particular embodiments are scalable, i.e., they can be configured to support any number of phases. Additionally, particular embodiments have a low profile, and some embodiments have small air gaps, or even no air gaps, which helps minimize potential for radiated electromagnetic interference (EMI) with other circuitry. Furthermore, particular embodiments implement electrical coupling of phases, which promotes fast transient response and/or low ripple current magnitude.

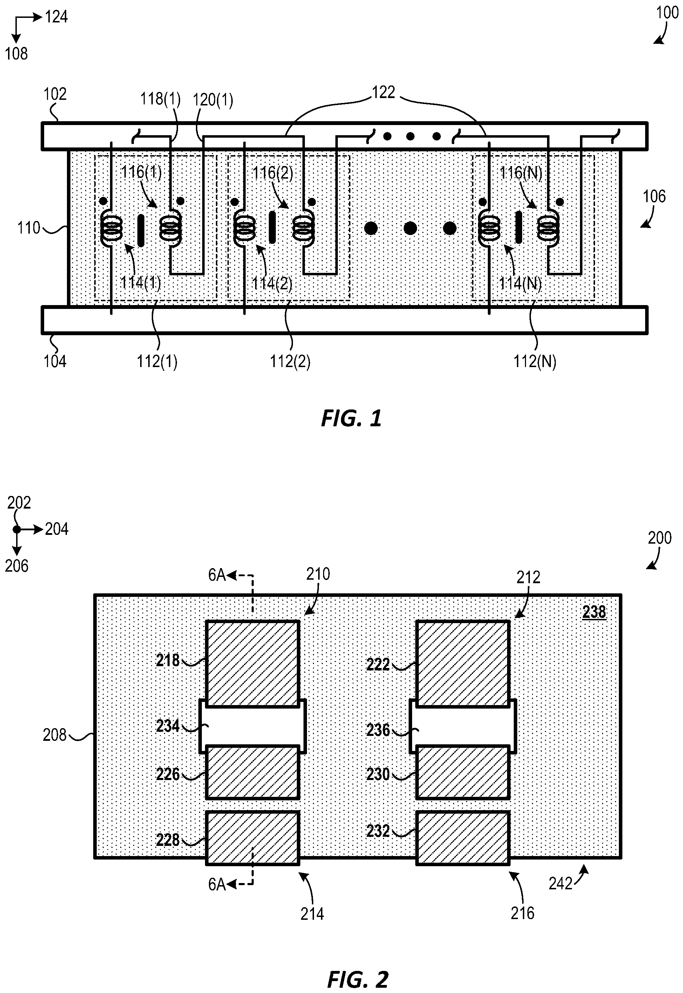

FIG. 1 is schematic diagram of an electrical assembly 100, which is one embodiment of the new electrical assemblies disclosed herein. Electrical assembly 100 includes a first substrate 102, a second substrate 104, and a magnetic device 106. In some embodiments, each of first substrate 102 and second substrate 104 is a respective PCB. First substrate 102 is separated from second substrate 104 is a direction 108, and magnetic device 106 is disposed between first substrate 102 and second substrate 104 in direction 108. Accordingly, magnetic device 106 is sandwiched between first substrate 102 and second substrate 104.

Magnetic device 106 includes a magnetic core 110 and N winding sets 112, where N is an integer greater than or equal to one. In this document, specific instances of an item may be referred to by use of a numeral in parentheses (e.g. winding set 112(1)) while numerals without parentheses refer to any such item (e.g. winding sets 112). While FIG. 1 illustrates N being equal to at least three, it is understood that N could alternately be equal to two or equal to one. Each winding set 112 includes a respective primary winding 114 and a respective secondary winding 116. The primary winding 114 and the secondary winding 116 of each winding set 112 are magnetically coupled. For example, primary winding 114(1) is magnetically coupled with secondary winding 116(1), and primary winding 114(2) is magnetically coupled with secondary winding 116(2). The windings of each winding set 112 are ideally not magnetically coupled with windings of each other winding set 112. For example, the windings of winding set 112(1) are ideally not magnetically coupled with the windings of winding set 112(2). However, there usually will be at least some magnetic coupling between windings of two or more winding sets 112 due to the winding sets 112 sharing a common magnetic core 110.

Each primary winding 114 extends through magnetic core 110 in first direction 108, and each primary winding 114 electrically couples first substrate 102 to second substrate 104. Each secondary winding 116 is wound around at least a portion of magnetic core 110, and opposing ends 118 and 120 of each secondary winding 116 are electrically coupled to first substrate 102. Only one instance of secondary winding 116 ends 118 and 120 are labeled in FIG. 1 for illustrative clarity. Secondary windings 116 are electrically coupled in series by one or more electrical conductors 122 on first substrate 102. While not required, electrical assembly 100 will commonly include additional elements, such as switching stages and capacitors, which cooperate with magnetic device 110 to collectively form a multi-phase switching power converter. While FIG. 1 illustrates winding sets 112 being separated from each other in a direction 124 that is orthogonal to direction 108, winding sets 112 could alternately and/or additionally be separated from each in a third direction that is orthogonal to each of directions 108 and 124, i.e., in a direction that is normal to the page of FIG. 1.

Discussed below are several example of embodiments of magnetic device 106 as well as several example embodiments of electrical assembly 100. It is understood, though, that magnetic device 106 and electrical assembly 100 are not limited to the example embodiments discussed below.

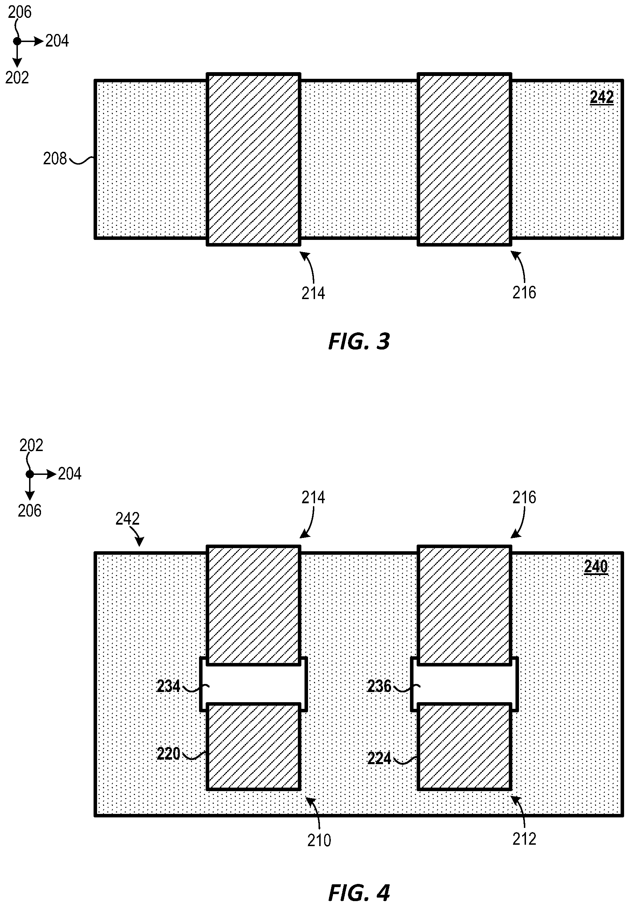

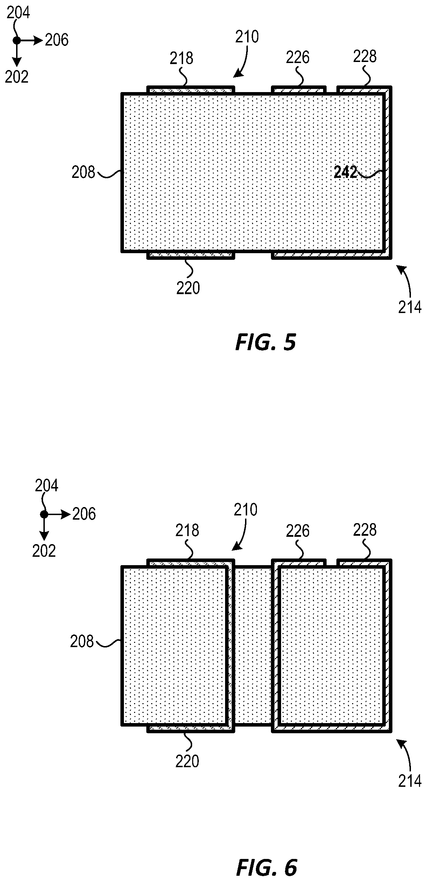

FIGS. 2-6 collectively illustrate a magnetic device 200, where magnetic device 200 is one possible embodiment of magnetic device 106 of FIG. 1 where N is equal to two. FIG. 2 is a top plan view of magnetic device 200, FIG. 3 is a front elevational view of magnetic device 200, FIG. 4 is a bottom plan view of magnetic device 200, FIG. 5 is a side elevational view of magnetic device 200, and FIG. 6 is a cross-sectional view of magnetic device 200 taken along line 6A-6A of FIG. 2. The terms "top," bottom," "front," and "side" in this document are used for convenience and do not require any particular orientation of their associated elements. For example, the top of magnetic device 200 illustrated in FIG. 2 may be considered a side of magnetic device 200 in applications where magnetic device 200 is rotated by 90 degrees relative to its orientation in FIGS. 2-6. FIGS. 2-6 collectively illustrate coordinate axes including a first direction 202, a second direction 204, and a third direction 206, where the second direction 204 is orthogonal to the first direction 202, and the third direction 206 is orthogonal to each of the first direction 202 and the second direction 204.

Magnetic device 200 includes a magnetic core 208, a first primary winding 210, a second primary winding 212, a first secondary winding 214, and a second secondary winding 216. Magnetic core 208 is an embodiment of magnetic core 110 (FIG. 1), each of first primary winding 210 and second primary winding 212 is an embodiment of a primary winding 114 instance (FIG. 1), and each of first secondary winding 214 and second secondary winding 216 is an embodiment of a secondary winding 116 instance (FIG. 1). First primary winding 210 has opposing ends 218 and 220, and second primary winding 212 has opposing ends 222 and 224. First secondary winding 214 has opposing ends 226 and 228, and second secondary winding 216 has opposing ends 230 and 232.

Magnetic core 208 forms a first winding window 234 and a second winding window 236 extending through magnetic core 208 in first direction 202. First winding window 234 and second winding window 236 are separated from each other in second direction 204. First primary winding 210 is wound through first winding window 234 such that first primary winding 210 extends through magnetic core 208 in first direction 202. Additionally, first primary winding 210 is wound through first winding window 234 and around a portion of magnetic core 208 such that (i) end 218 of first primary winding 210 is on a top outer surface 238 of magnetic core 208 and (ii) end 220 of first primary winding 210 is on a bottom outer surface 240 of magnetic core 208, where bottom outer surface 240 is opposite of top outer surface 238. Similarly, second primary winding 212 is wound through second winding window 236 and around a portion of magnetic core 208 that (i) end 222 of second primary winding 212 is on top outer surface 238 of magnetic core 208 and (ii) end 224 of second primary winding 212 is on bottom outer surface 240 of magnetic core 208.

First secondary winding 214 is wound through first winding window 234, along bottom outer surface 240 of magnetic core 208, and along a front outer surface 242 of magnetic core 208 such that of end 226 and end 228 of first secondary winding 214 are each on top outer surface 238 of magnetic core 208. Front outer surface 242 of magnetic core 208 joins top outer surface 238 of magnetic core 208 and bottom outer surface 240 of magnetic core 208 in first direction 202. Additionally, second secondary winding 216 is wound through second winding window 236, along bottom outer surface 240 of magnetic core 208, and along front outer surface 242 of magnetic core 208 such that of end 230 and end 232 of second secondary winding 216 are each on top outer surface 238 of magnetic core 208. First secondary winding 214 is separated from first primary winding 210 in third direction 206 within first winding window 234, and second secondary winding 216 is separated from second primary winding 212 in third direction 206 within second winding window 236.

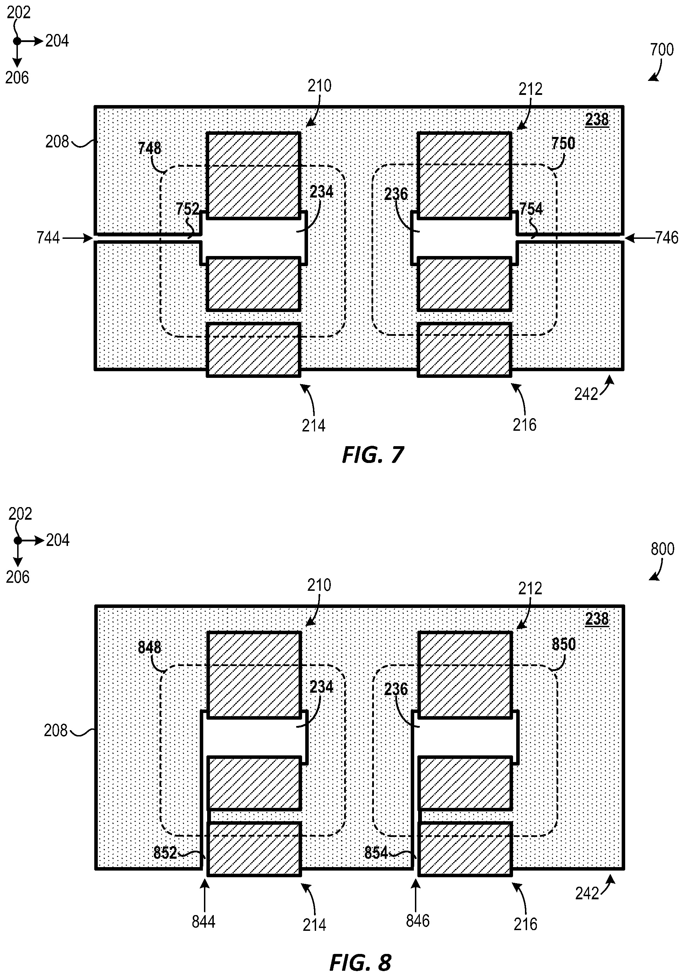

Magnetic core 208 is formed, for example, of a ferrite magnetic material. Particular embodiments of magnetic core 208 include (i) a first gap in series with a magnetic flux path in magnetic core 208 magnetically coupling first primary winding 210 and first secondary winding 214 and (ii) a second gap in series with a magnetic flux path in magnetic core 208 magnetically coupling second primary winding 212 and second secondary winding 216. For example, FIG. 7 is a top plan view of a magnetic device 700, where magnetic device 700 is an embodiment of magnetic device 200 (FIGS. 2-6) where magnetic core 208 forms a first gap 744 and a second gap 746. First gap 744 is in series with a magnetic flux path 748 in magnetic core 208 magnetically coupling first primary winding 210 and first secondary winding 214, and second gap 746 is in series with a magnetic flux path 750 magnetically coupling second primary winding 212 and second secondary winding 216. First gap 744 is filled with a first gap material 752, and second gap 746 is filled with a second gap material 754, where each of first gap material 752 and second gap material 754 have a lower magnetic permeability than a magnetic material forming magnetic core 208. For example, in certain embodiments, first gap material 752 and second gap material 754 each include one or more of air, paper, plastic, glue, and low permeability magnetic material.

Respective locations of first gap 744 and second gap 746 may vary, although it is generally desirable that the gaps not be located in a portion of magnetic core that is within magnetic flux paths of both first primary winding 210 and second primary winding 212, to help minimize magnetic coupling of first primary winding 210 and second primary winding 212. Accordingly, it is generally desirable that gaps in magnetic core 208 not be located in a portion of magnetic core 208 between first winding window 234 and second winding window 236.

FIG. 8 illustrates another possible location of gaps in magnetic core 208. Specifically, FIG. 8 is a top plan view of a magnetic device 800, where magnetic device 800 is an embodiment of magnetic device 200 (FIGS. 2-6) where magnetic core 208 forms a first gap 844 and a second gap 846. First gap 844 is in series with a magnetic flux path 848 in magnetic core 208 magnetically coupling first primary winding 210 and first secondary winding 214, and second gap 846 is in series with a magnetic flux path 850 magnetically coupling second primary winding 212 and second secondary winding 216. First gap 844 is filled with a first gap material 852 analogous to first gap material 752 of FIG. 7, and second gap 846 is filled with a second gap material 854 analogous to second gap material 754 of FIG. 7.

Returning to FIGS. 2-6, magnetic core 208 could alternately be formed of magnetic material having a distributed gap instead of being formed of ferrite material or other high permeability magnetic material. For example, magnetic core 208 could be formed of material including powered iron and a binder instead of being formed of a ferrite material. In certain of these embodiments where magnetic core 208 is formed of a magnetic material having a distributed gap, magnetic core 208 does not necessarily form explicit gaps.

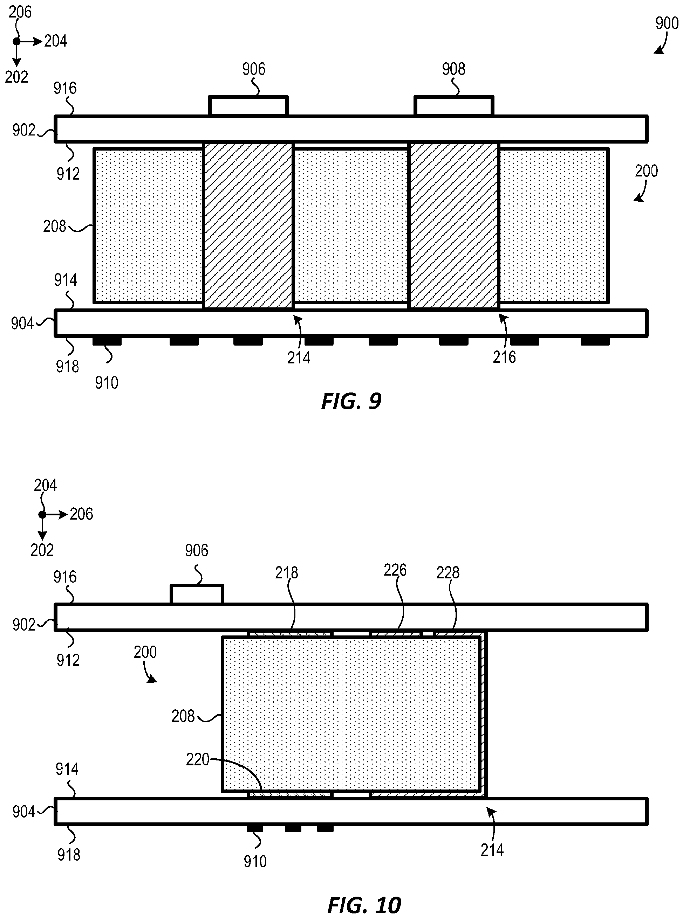

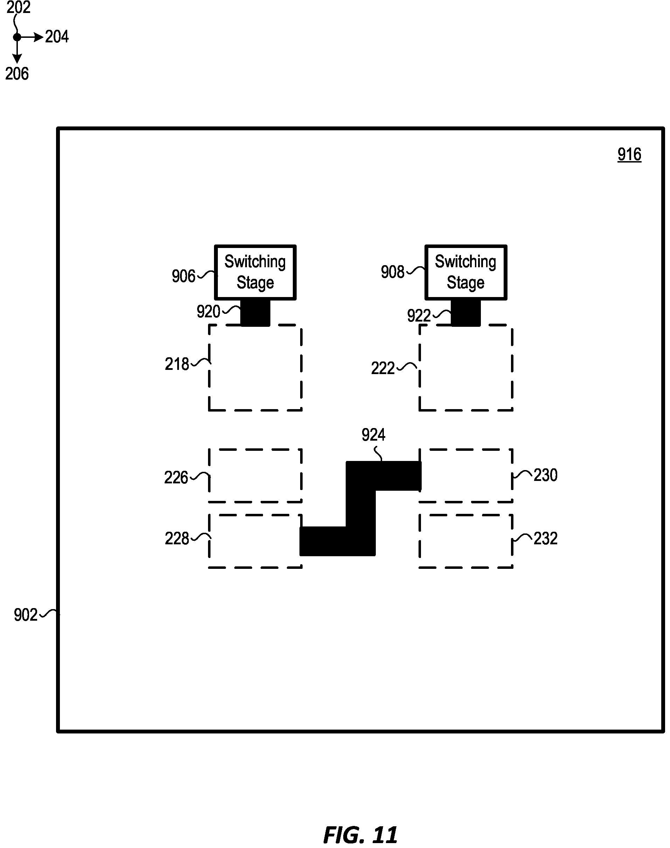

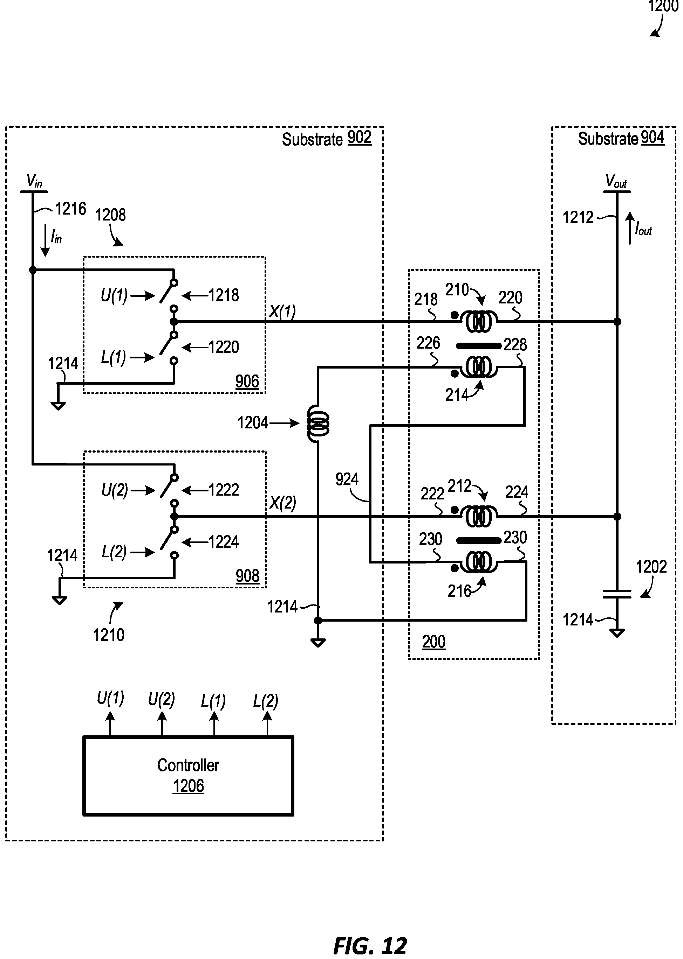

FIGS. 9-11 illustrate an electrical assembly 900, where electrical assembly 900 is one embodiment of an electrical assembly 100 (FIG. 1) where magnetic device 106 is embodied by magnetic device 200 (FIGS. 2-6). FIG. 9 is a front elevational view of electrical assembly 900, FIG. 10 is a side elevational view of electrical assembly 900, and FIG. 11 is a top plan view of electrical assembly 900. FIGS. 9-11 include the same coordinate axes as FIGS. 2-6. Electrical assembly 900 includes a first substrate 902, a second substrate 904, an instance of magnetic device 200, a first switching stage 906, a second switching stage 908, and a plurality of capacitors 910, only one of which is labeled in FIGS. 9 and 10. Electrical assembly 900 may include additional elements, such as discussed below with respect to FIG. 12, without departing from the scope hereof. First substrate 902 is an embodiment of first substrate 102 (FIG. 1), and second substrate 904 is an embodiment of second substrate 104 (FIG. 1). First substrate 902 and second substrate 904 are separated from each other in first direction 202, and magnetic device 200 is disposed between first substrate 902 and second substrate 904 in first direction 202. End 218 of first primary winding 210, end 222 of second primary winding 212, ends 226 and 228 of first secondary winding 214, and ends 230 and 232 of second secondary winding 216 are connected to a bottom surface 912 of first substrate 902 by surface mount soldering. End 220 of first primary winding 210 and end 224 of second primary winding 212 are connected to a top surface 914 of second substrate 904 by surface mount soldering. In some alternate embodiments, the winding ends are connected to first substrate 902 and/or second substrate 904 by a method other than surface mount soldering, such as by through-hole pins soldered into plated through-holes in the substrates.

FIG. 11 illustrates in dashed lines outlines of winding ends that are connected to bottom surface 912 of first substate 902, where bottom surface 912 is opposite of a top surface 914 of first substrate. Each of first switching stage 906 and second switching stage 908 is on first substrate 902. First switching stage 906 is electrically coupled 920 to end 218 of first primary winding 210, and second switching stage 908 is electrically coupled 922 to end 222 of second primary winding 212. An electrical conductor 924 of first substrate 902 electrically couples end 228 of first secondary winding 214 to end 230 of second secondary winding 216, thereby coupling first secondary winding 214 and second secondary winding 216 in series. Electrical conductor 924 includes, for example, a PCB trace or a PCB conductive polygon. Capacitors 910 are located on a bottom surface 918 of second substrate 904. In certain embodiments, capacitors 910 are electrically coupled to each of end 220 of first primary winding 210 and end 224 of second primary winding 212.

In particular embodiments, magnetic device 200, first switching stage 906, second switching stage 908, and capacitors 910 form part of a multi-phase switching power converter. For example, FIG. 12 is an electrical schematic diagram of a multi-phase switching power converter 1200 at least partially formed by elements of electrical assembly 900. It is understood, though, that electrical assembly 900 is not limited to forming the FIG. 12 multi-phase switching power converter. Multi-phase switching power converter 1200 includes an instance of magnetic device 200, first switching stage 906, second switching stage 908, output capacitance 1202, a tuning inductor 1204, and a controller 1206. Tuning inductor 1204 and controller 1206, which are not shown in FIGS. 9-11, are illustrated in FIG. 12 as being on first substrate 204. However, tuning inductor 1204 and/or controller 1206 could be located elsewhere without departing from the scope hereof. For example, tuning inductor 1204 and/or controller 1206 could be located on second substrate 904 instead of on first substrate 902. As another example, tuning inductor 1204 and/or controller 1206 could be located external to both of first substrate 902 and second substrate 904.

First switching stage 906, first primary winding 210, and first secondary winding 214 collectively form a first phase 1208 of multi-phase switching power converter 1200, and second switching stage 908, second primary winding 212, and second secondary winding 216 collectively form a second phase 1210 of multi-phase switching power converter 1200. First primary winding 210 is electrically coupled between a first switching node X(1) and an output power node 1212, and second primary winding 212 is electrically coupled between a second switching node X(2) and output power node 1212. Output power node 1212 has a voltage *Vₒᵤₜ* relative to a ground node 1214, and an output current *Iₒᵤₜ* flows to a load (not shown) electrically coupled to output power node 1212. Output current *Iₒᵤₜ* could have a negative polarity without departing from the scope hereof. Output capacitance 1202, which represents collective capacitance of all capacitors 910 of electrical assembly 900, is electrically coupled between output power node 1212 and ground node 1214. Ground node 1214 need not be an earth ground node, and ground node 1214 accordingly could be at a different electrical potential than an earth ground. For example, ground node 1214 could be reference node that is floating with respect to an earth ground.

First switching stage 906 is configured to repeatedly switch first switching node *X(1)* between an input power node 1216 and ground node 1214 in response to control signals *U(1)* and *L(1)* generated by controller 1206, and second switching stage 908 is configured to repeatedly switch second switching node *X(2)* between input power node 1216 and ground node 1214 in response to control signals *U(2)* and *L(2)* generated by controller 1206. Connections between controller 1206 and first switching stage 906 and second switching stage 908 are not shown for illustrative clarity, although it is understood that one or more communication buses may communicatively couple control signals *U* and *L* from controller 1206 to first switching stage 906 and second switching stage 908. Input power node 1216 is at a voltage *Vᵢₙ* relative to ground node 1214. Accordingly, first switching stage 906 repeatedly switches first switching node *X(1)* between voltage *Vᵢₙ* and zero volts relative to ground node 1214, and second switching stage 908 repeatedly switches second switching node *X(2)* between voltage *Vᵢₙ* and zero volts relative to ground node 1214. An input current *Iᵢₙ* flows from an electrical power source (not shown) to multi-phase switching power converter 1200 via input power node 1216. Input current *Iᵢₙ* could have a negative polarity without departing from the scope hereof. One or more input capacitors (not shown) are optionally electrically coupled between input power node 1216 and ground node 1214.

First switching stage 906 includes an upper switching device 1218 and a lower switching device 1220. Upper switching device 1218 is electrically coupled between input power node 1216 and first switching node *X(1)*, and lower switching device 1220 is electrically coupled between first switching node *X(1)* and ground node 1214. Second switching stage 908 includes an upper switching device 1222 and a lower switching device 1224. Upper switching device 1222 is electrically coupled between input power node 1216 and second switching node *X(2)*, and lower switching device 1224 is electrically coupled between second switching node *X(2)* and ground node 1214. Upper switching devices 1218 and 1222 switch in response to a respective control signals *U(1)* and *U(2)* from controller 1206, and lower switching devices 1220 and 1224 switch in response to a respective control signals *L(1)* and *L(2)* from controller 1206. Each of upper switching device 1218, lower switching device 1220, upper switching device 1222, and lower switching device 1224 includes, for example, one or more transistors.

First secondary winding 214, second secondary winding 216, and tuning inductor 1204 are electrically coupled in series. While FIG. 12 illustrates the series connection including first secondary winding 214, second secondary winding 216, and tuning inductor 1204 being reference to ground node 1214, in some alternate embodiments, these elements are electrically coupled in series without being referenced to ground node 1214. Tuning inductor 1204 could be omitted without departing from the scope hereof, such as in embodiments where there is significant stray inductance in magnetic device 200.

Controller 1206 is implemented, for example, by analog and/or electronic circuitry. In some embodiments, controller 1206 is at least partially implemented by a processor (not shown) executing instructions in the form of software and/or firmware stored in a memory (not shown). Although controller 1206 is depicted as a discrete element for illustrative simplicity, controller 1206 could be partially or fully integrated with one or more other elements of multi-phase switching power converter 1200. For example, some subsystems of controller 1206 could be incorporated in one or more of first switching stage 906 and second switching stage 908. Additionally, FIG. 12 should not be construed to require that there be a separate communication bus for each control signal. For example, controller 1206 could be implemented by a combination of a central integrated circuit and local control logic integrated in each of first switching stage 906 and second switching stage 908, with a single communication bus running from the central integrated circuit to each of first switching stage 906 and second switching stage 908. Furthermore, controller 1206 may include multiple constituent elements that need not be co-packaged or even disposed at a common location

Controller 1206 is configured to generate control signals *U* and *L* to control duty cycle (D) of each of first phase 1208 and 2120, where duty cycle of phase 1208 or 1210 is a portion of a switching cycle of the phase that the respective primary winding 210 or 212 of the phase is driven high, i.e., when the switching node *X(1)* or *X(2)* of the phase is connected to input power node 1216, to regulate at least one parameter of multi-phase switching power converter 1200. In some embodiments, controller 1206 is configured to control duty cycle of first phase 1208 and second phase 1210 using pulse width modulation (PWM) and/or pulse frequency modulation (PFM). Examples of possible regulated parameters include, but are not limited, magnitude of input voltage *Vᵢₙ*, magnitude of input current *Iᵢₙ*, magnitude of output voltage *Vₒᵤₜ*, and magnitude of output current *Iₒᵤₜ.* For example, in some embodiments, controller 1206 is configured to generate control signals *U* and *L* to regulate magnitude of output voltage *Vₒᵤₜ*, and controller 1206 accordingly generates control signals *U* and *L* during continuous conduction operation of multi-phase switching power converter 1200 such that duty cycle of each of first phase 1208 and second phase 1210 is equal to a ratio of output voltage magnitude *Vₒᵤₜ* over input voltage magnitude *Vᵢₙ*. For example, if output voltage *Vₒᵤₜ* is to be regulated to two volts and input voltage *Vᵢₙ* is eight volts, controller 1206 would generate control signals *U* and *L* such that duty cycle of each of first phase 1208 and second phase 1210 is 0.25. Controller 1206 is optionally configured to generate control signals *U* and *L* such that first phase 1208 and second phase 1210 switch out-of-phase with each other.

It should be appreciated that first phase 1208 and second phase 1210 are electrically coupled by the series connection of first secondary winding 214 and second secondary winding 216 via electrical conductor 924 of first substrate 902 (FIG. 11). The electrical coupling of first phase 1208 and second phase 1210 advantageously promotes fast transient response and/or low ripple current magnitude relative to an otherwise similar multi-phase switching power converter without electrical coupling of phases.

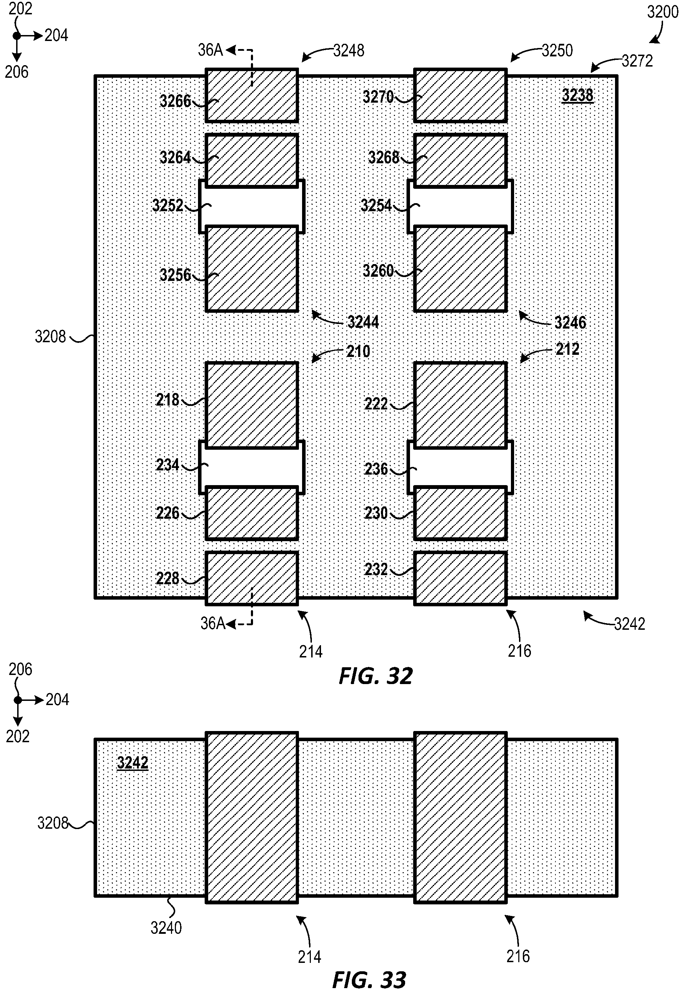

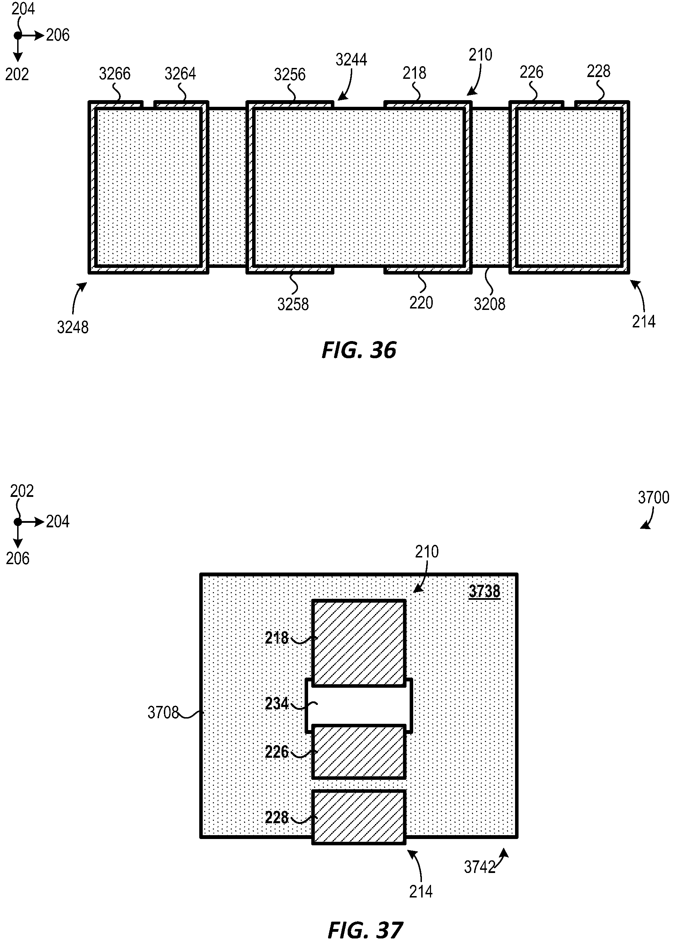

Multi-phase switching power converter 1200 could be modified to include additional phases by adding a respective switching stage for each additional phase, as well as by modifying magnetic device 200 to include an additional primary winding and an additional secondary winding for each additional phase. One example of an alternate embodiment of magnetic device 200 including additional primary and second winding pairs is discussed below with respect to FIGS. 32-36. Additionally, while each of first phase 1208 and second phase 1210 powers common output power node 1212 in multi-phase switching power converter 1200, multi-phase switching power converter 1200 could be modified so that two or more phases power different output power nodes. Furthermore, although each of first phase 1208 and second phase 1210 is powered by a common input power node 1216 in multi-phase switching power converter 1200, multi-phase switching power converter 1200 could be modified so that two or more phases are powered by different respective input power nodes. Moreover, while multi-phase switching power converter 1200 has a buck topology, multi-phase switching power converter 1200 could be modified to have a different topology, e.g., a boost topology or a buck-boost topology. Additionally, while a single tuning inductor 1204 electrically couples two phases of multi-phase switching power converter 1200 in FIG. 12, tuning inductor 1204 could similarly couple more phases. For example, tuning inductor 1204 could be electrically coupled in series with each secondary winding in a four-phase switching power converter incorporating a magnetic device with four winding sets, such as a magnetic device 3200 discussed below with respect FIG. 32. Furthermore, a single tuning inductor 1204 could be electrically coupled is series with secondary windings of several magnetic devices having different respective quantities of winding sets. For example, a single instance of tuning inductor 1204 could be electrically coupled in series with each of (i) secondary windings of one instance of magnetic device 3200 of FIG. 32, (ii) the respective secondary windings of two instances of magnetic device 200, (iii) the respective secondary windings of three instances of a magnetic device with a single winding set, such as magnetic device 3700 discussed below with respect to FIG. 37.

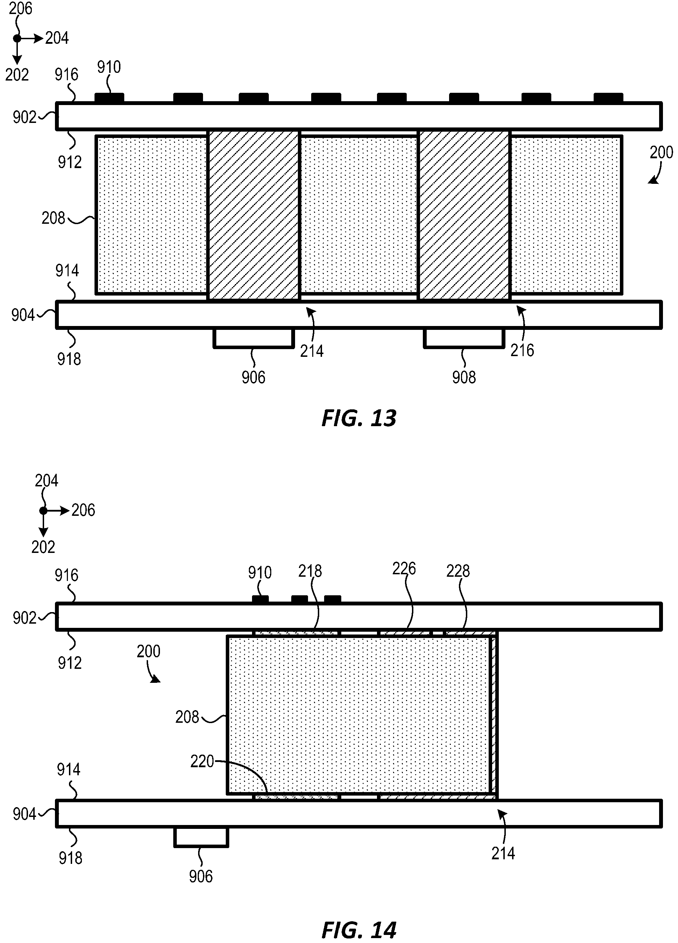

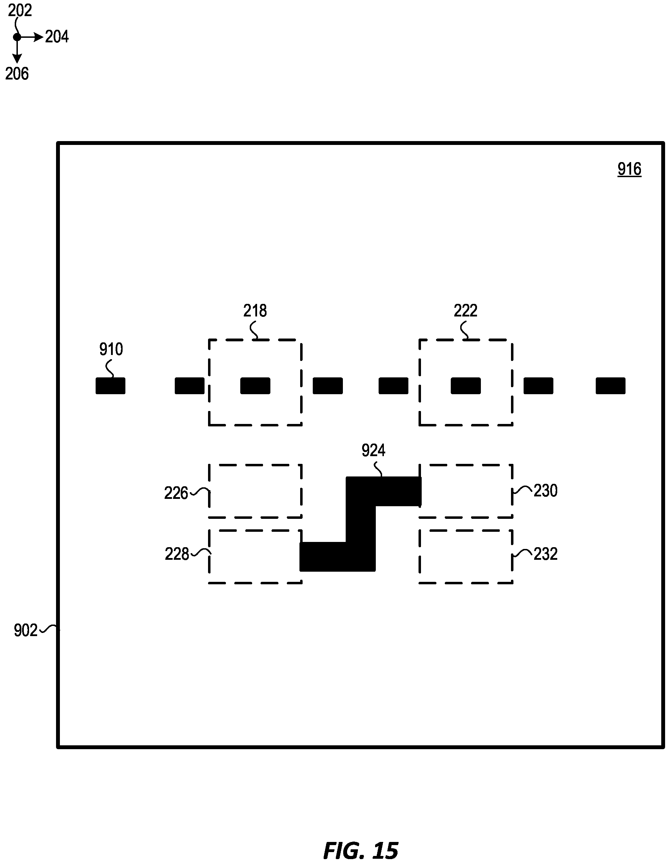

FIGS. 13-15 illustrate an electrical assembly 1300, which is an alternate embodiment of electrical assembly 900 (FIGS. 9-11) where (i) each of first switching stage 906 and second switching stage 908 are located on second substrate 904 instead of on first substrate 902 and (ii) capacitors 910 are located first substrate 902 instead of on second substrate 904. FIG. 13 is a front elevational view of electrical assembly 1300, FIG. 14 is a side elevational view of electrical assembly 1300, and FIG. 15 is a top plan view of electrical assembly 1300. Only one instance of a capacitor 910 is labeled in each FIGS. 13-15. Electrical assembly 1300 optionally forms at least part of a multi-phase switching power converter similar to multi-phase switching power converter 1200 of FIG. 12, but with opposing ends of each winding swapped. For example, end 218 of first primary winding 210 is connected to output power node 1212 instead of to first switching node *X(1)*, and end 220 of first primary winding 210 is electrically coupled to first switching node *X(1)* instead of to output power node 1212, in embodiments of electrical assembly 1300 forming a multi-phase switching power converter similar to multi-phase switching power converter 1200.

Referring again to FIG. 2, it is anticipated first secondary winding 214 and second secondary winding 216 will frequently conduct zero, or essentially zero, direct current (DC) in multi-phase switching power converter applications of magnetic device 200. Consequently, in particular embodiments, first secondary winding 214 and second secondary winding 216 need not be capable of carrying as much current as first primary winding 210 and second primary winding 212. While it may be desirable for all windings of magnetic device 200 to have a common thickness to promote planarity, in some applications, first secondary winding 214 and second secondary winding 216 may be modified to have smaller widths than first primary winding 210 and second primary winding 212 due to the secondary windings carrying current of smaller magnitude than the primary windings.

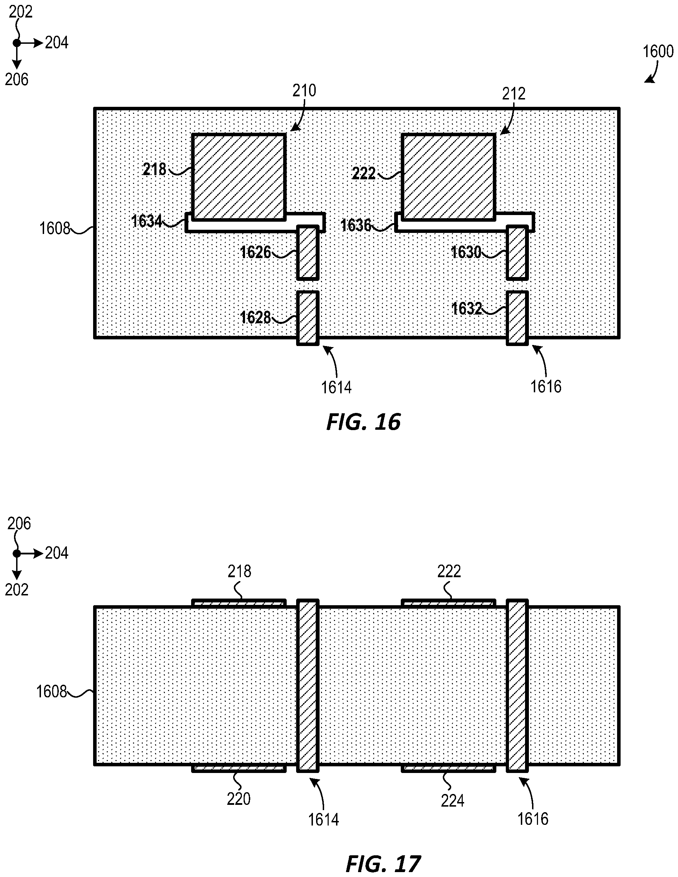

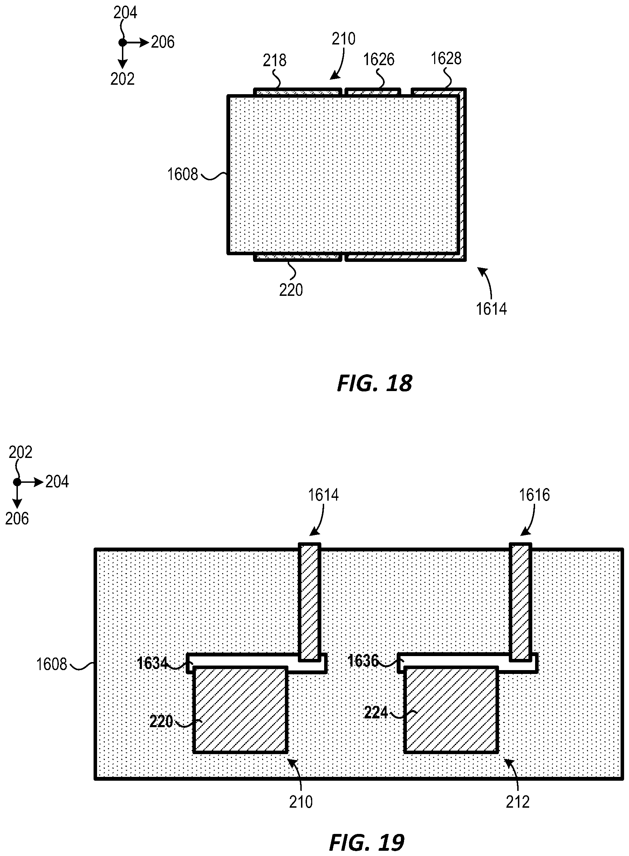

For example, FIGS. 16-19 collectively illustrate a magnetic device 1600, which is an alternate embodiment of magnetic device 200 (FIGS 2-6) having a different secondary winding configuration, as well as a different winding window configuration. FIG. 16 is a top plan view of magnetic device 1600, FIG. 17 is a front elevational view of magnetic device 1600, FIG. 18 is a side elevational view of magnetic device 1600, and FIG. 19 is a bottom plan view of magnetic device 1600. Magnetic device 1600 differs from magnetic device 200 in that (i) magnetic core 208 is replaced with a magnetic core 1608, (ii) first secondary winding 214 is replaced with a first secondary winding 1614, and (iii) second secondary winding 216 is replaced with a second secondary winding 1616. Magnetic core 1608 differs from magnetic core 208 in its dimensions and that first winding window 234 and second winding window 236 are replaced with a first winding window 1634 and a second winding window 1636, respectively. First winding window 1634 and second winding window 1636 are longer in second direction 204 than corresponding winding windows in magnetic core 208, but first winding window 1634 and second winding window 1636 are narrower in third direction 206 than corresponding winding windows in magnetic core 208. Consequently, magnetic core 1608 is longer is second direction 204, but narrower in third direction 206, than magnetic core 208.

First secondary winding 1614 and second secondary winding 1616 are narrower than first secondary winding 214 and second secondary winding 216, respectively. First secondary winding 1614 has opposing ends 1626 and 1628 in place of opposing ends 226 and 228, respectively. Additionally, second secondary winding 1616 has opposing ends 1630 and 1632 in place of opposing ends 230 and 232, respectively. First primary winding 210 is separated from first secondary winding 1614 in first winding window 1634 in second direction 204, and second primary winding 212 is separated from second secondary winding 1616 in second winding window 1636 in second direction 204.

Referring again to FIG. 1, stray inductance between the primary winding 114 and the secondary winding 116 in a given winding set 112 can be helpful in some applications. For example, if such inductance is sufficiently large, it may eliminate the need for a tuning inductor, e.g., tuning inductor 1204 of FIG. 12, in embodiments where electrical assembly 100 forms part of a multi-phase switching power converter. However, excessive inductance between the primary winding 114 and the secondary winding 116 in a given winding set 112 may be detrimental because it impairs transient response of a multi-phase switching power converter including electrical assembly 100. Stray inductance between the primary winding 114 and the secondary winding 116 in a given winding set 112 can be reduced by reducing size of a current loop incorporating the primary winding 114 and the secondary winding 116 of a given winding set 112. Accordingly, any of the magnetic devices disclosed herein may include a respective ground conductor near each secondary winding, to help cause ground current flowing between opposing substrates to flow near the secondary windings, thereby helping reduce stray inductance between the primary winding 114 and the secondary winding 116 of each winding set 112. The ground conductors electrically couple a ground node of first substrate 102 to a ground node of second substrate 104.

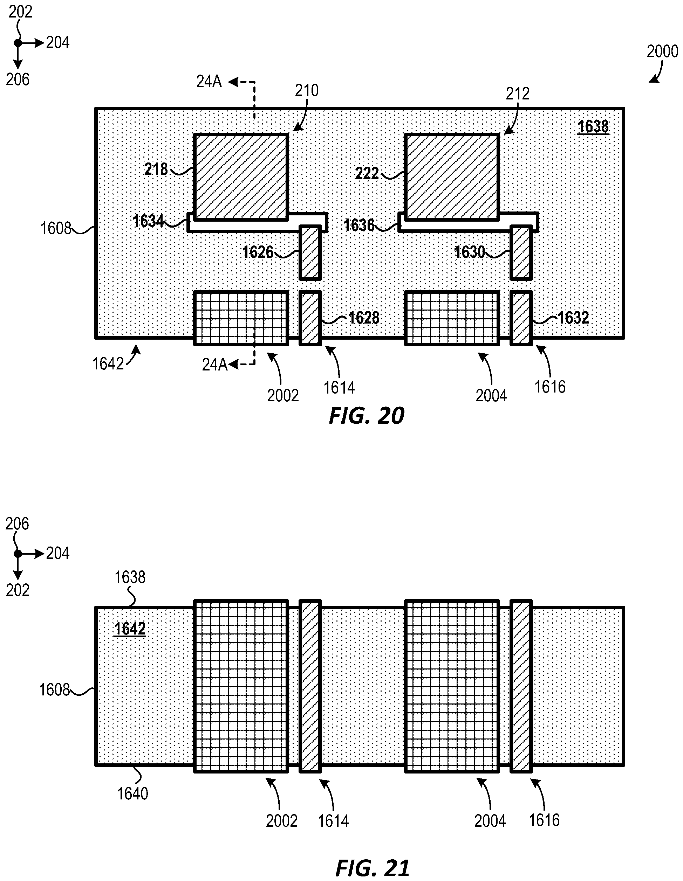

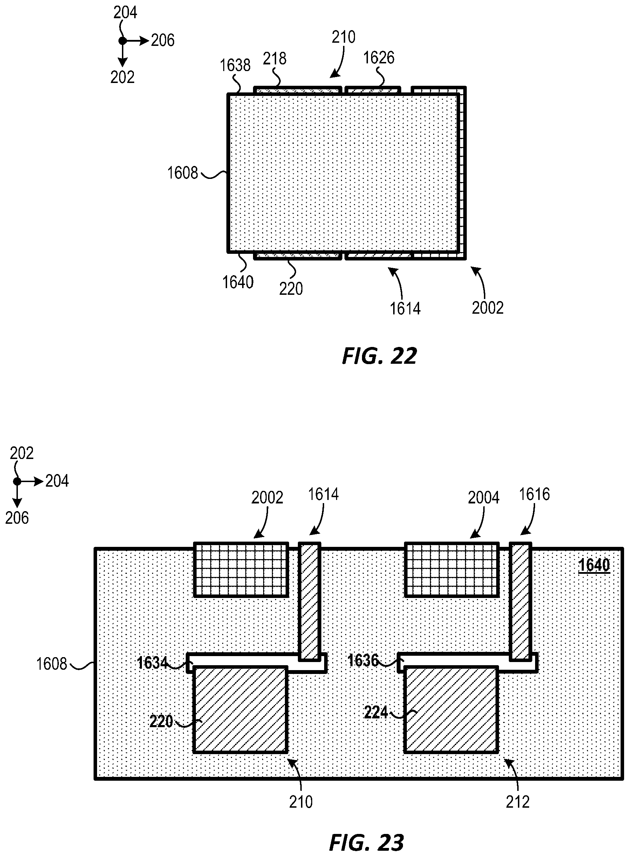

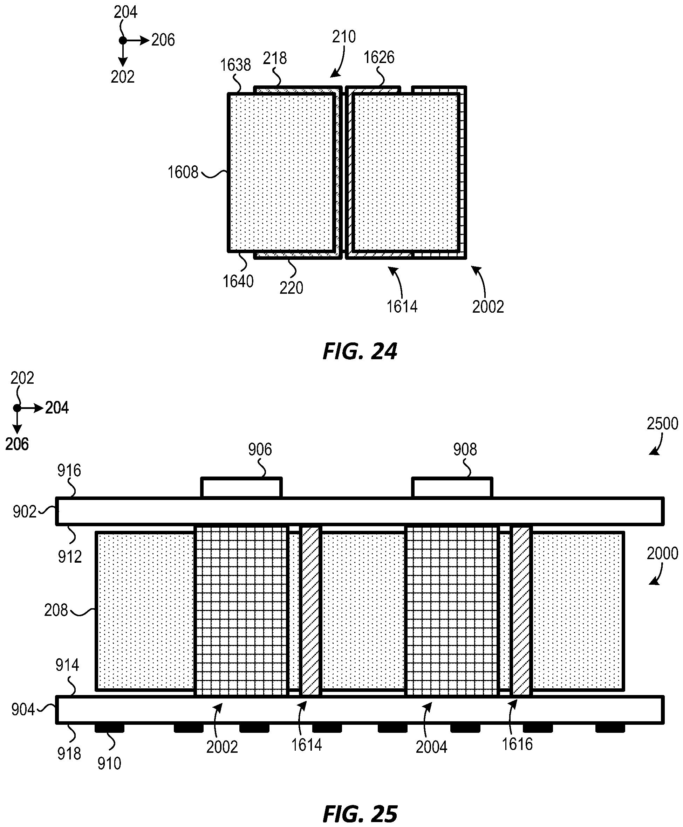

For example, FIGS. 20-24 illustrate a magnetic device 2000, where magnetic device 2000 is an alternate embodiment of magnetic device 1600 (FIGS. 16-19) further including a respective ground conductor for each secondary winding. FIG. 20 is a top plan view of magnetic device 2000, FIG. 21 is a front elevational view of magnetic device 2000, FIG. 22 is a side elevational view of magnetic device 2000, FIG. 23 is a bottom elevational view of magnetic device 2000, and FIG. 24 is a cross-sectional view of magnetic device 2000 taken along line 24A-24A of FIG. 20. Magnetic device 2000 differs from magnetic device 1600 in that magnetic device 2000 further includes (i) a first ground conductor 2002 disposed adjacent to first secondary winding 1614 and (ii) a second ground conductor 2004 disposed adjacent to second secondary winding 1616. Each of first ground conductor 2002 and second ground conductor 2004 extend along a side outer surface 1642 of magnetic core 1608, and each of first ground conductor 2002 and second ground conductor 2004 wraps around magnetic core 1608 to extend over each of a top outer surface 1638 of magnetic core 1608 and a bottom outer surface 1640 of magnetic core 1608. Neither first ground conductor 2002 nor second ground conductor 2004, however, forms a complete loop around any portion of magnetic core 1608, to help minimize inductance associated with first ground conductor 2002 and second ground conductor 2004.

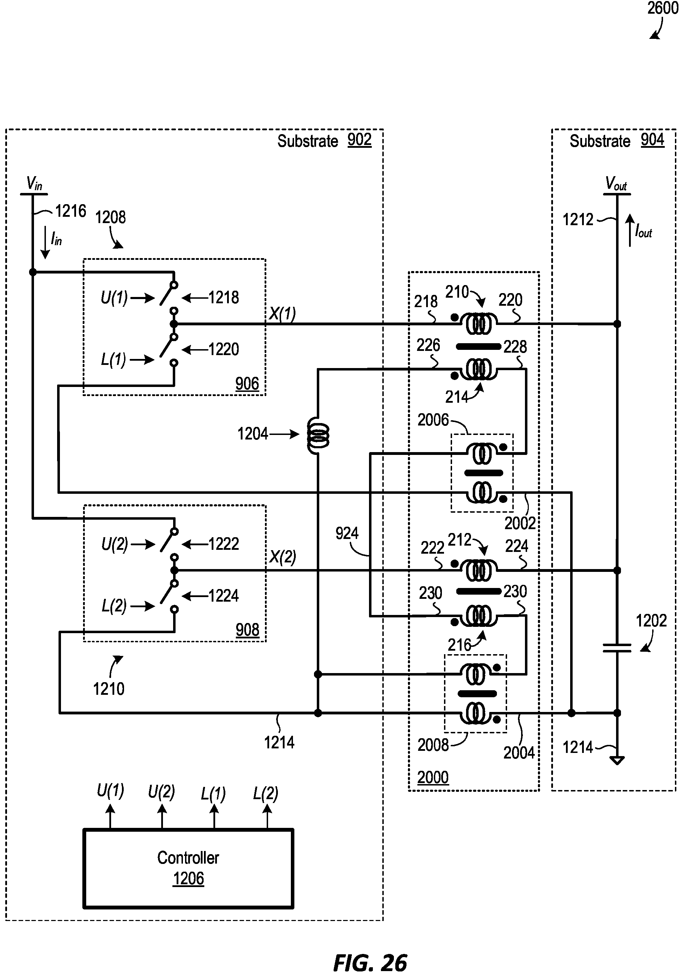

FIG. 25 is a front elevational view of an electrical assembly 2500, which is an alternate embodiment of electrical assembly 900 (FIGS. 9-11) with magnetic device 200 replaced with magnetic device 2000. Opposing ends of each of first ground conductor 2002 and second ground conductor 2004 are surface mount soldered to first substrate 902 and second substrate 904, respectively, although first ground conductor 2002 and second ground conductor 2004 could be connected to first substrate 902 and/or second substrate 904 in an alternative manner, e.g., by through-hole pins. Each of first ground conductor 2002 and second ground conductor 2004 electrically couple a ground node of first substrate 902 and a ground node of second substrate 904. For example, FIG. 26 is an electrical schematic diagram of a multi-phase switching power converter 2600 at least partially formed by elements of the FIG. 25 electrical assembly. Multi-phase switching power converter 2600 is the same as multi-phase switching power converter 1200 of FIG. 12 except that multi-phase switching power converter 2600 includes magnetic device 2000 in place of magnetic device 200. First ground conductor 2002 and second ground conductor 2004 electrically couple respective ground nodes 1214 of each of first substrate 902 and second substrate 904, as shown in FIG. 26. Additionally, FIG. 26 illustrates (i) magnetic coupling 2006 of first secondary winding 214 and first ground conductor 2002 and (ii) magnetic coupling 2008 of second secondary winding 216 and second ground conductor 2004.

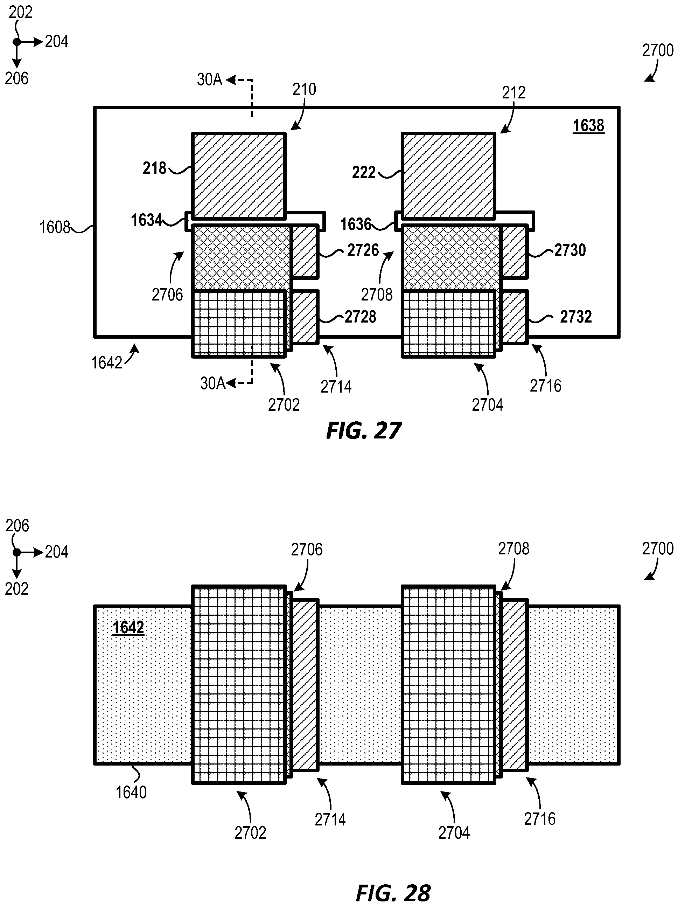

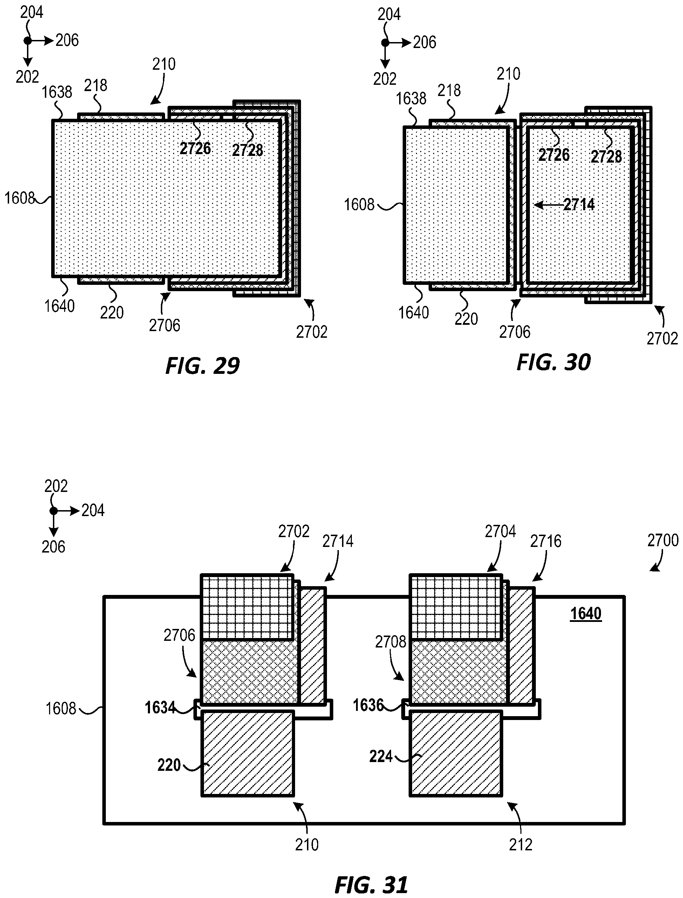

The magnetic devices disclosed herein could also include a respective ground conductor wound around each secondary winding, to help minimize separation between the ground conductors and the secondary windings. For example, FIGS. 27-31 illustrate a magnetic device 2700, which is an alternate embodiment of magnetic device 1600 (FIGS. 16-19) including a respective ground conductor wound around each secondary winding. FIG. 27 is top plan view of magnetic device 2700, FIG. 28 is a front elevational view of magnetic device 2700, FIG. 29 is a side elevational view of magnetic device 2700, FIG. 30 is a cross-sectional view of magnetic device 2700 taken along line 30A-30A of FIG. 27, and FIG. 31 is a bottom plan view of magnetic device 2700. Magnetic device 2700 differs from magnetic device 1600 in that (i) first secondary winding 1614 and second secondary winding 1616 are replaced with a first secondary winding 2714 and a second secondary winding 2716, respectively, (ii) magnetic device 2700 further includes a first insulating layer 2706 and a second insulating layer 2708, and (iii) magnetic device 2700 further includes a first ground conductor 2702 and a second ground conductor 2704.

First secondary winding 2714 is wound through first winding window 1634, along bottom outer surface 1640 of magnetic core 1608, and along side outer surface 1642 of magnetic core 1608 such that an end 2726 and an end 2728 of first secondary winding 2714 are each on top outer surface 1638 of magnetic core 1608. Additionally, second secondary winding 2716 is wound through second winding window 1636, along bottom outer surface 1640 of magnetic core 1608, and along side outer surface 1642 of magnetic core 1608 such that an end 2730 and an end 2732 of second secondary winding 2716 are each on top outer surface 1638 of magnetic core 1608. First secondary winding 2714 is separated from first primary winding 210 in third direction 206 within winding window 1634, and second secondary winding 2716 is separated from second primary winding 212 in third direction 206 within winding window 1636.

First insulating layer 2706 is wrapped over first secondary winding 2714, and first ground conductor 2702 is wrapped over first insulating layer 2706. Additionally, second insulating layer 2708 is wrapped over second secondary winding 2716, and second ground conductor 2704 is wrapped over second insulating layer 2708. As such, first ground conductor 2702 is wound around first secondary winding 2714, but first ground conductor 2702 is separated from first secondary winding 2714 by first insulating layer 2706 to prevent electrical shorting of first secondary winding 2714 and first ground conductor 2702. Additionally, second ground conductor 2704 is wound around second secondary winding 2716, but second ground conductor 2704 is separated from second secondary winding 2716 by second insulating layer 2708 to prevent electrical shorting of second secondary winding 2716 and second ground conductor 2704. Accordingly, each of first ground conductor 2702 and second ground conductor 2704 extend along side outer surface 1642 of magnetic core 1608, and each of first ground conductor 2702 and second ground conductor 2704 wraps around magnetic core 1608 to extend over each of top outer surface 1638 of magnetic core 1608 and bottom outer surface 1640 of magnetic core 1608. Neither first ground conductor 2702 nor second ground conductor 2704, however, forms a complete loop around any portion of magnetic core 1608, to help minimize inductance associated with first ground conductor 2702 and second ground conductor 2704.

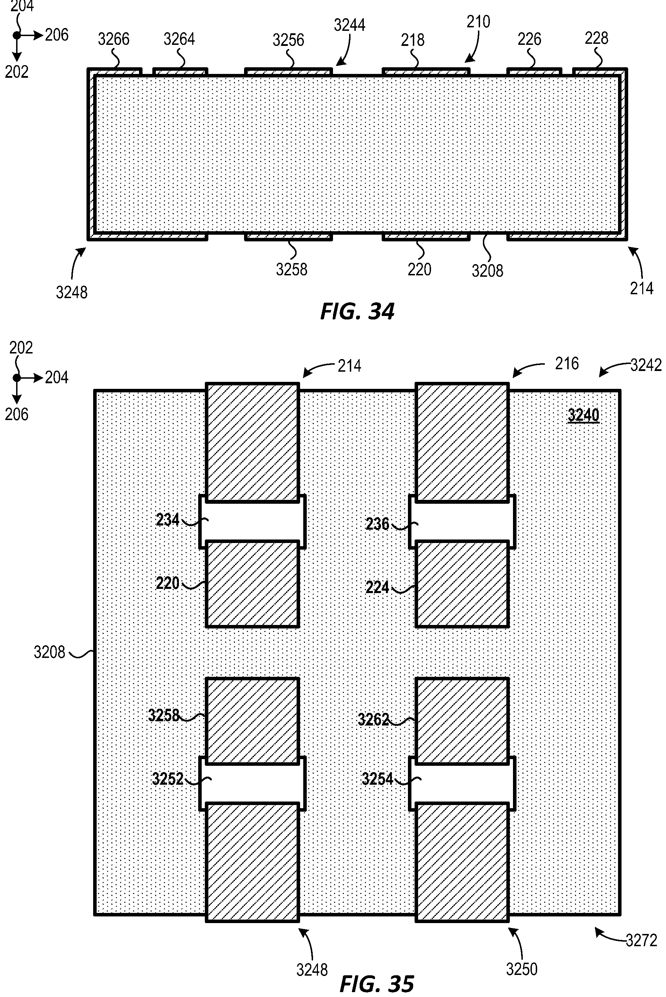

The magnetic devices discussed above with respect to FIGS. 2-31 include two winding sets, where each winding set includes a respective primary winding and a respective secondary winding. However, any of the above-discussed magnetic devices could be modified to include one or more additional winding sets, such as to support additional phases in a multi-phase switching power converter. For example, magnetic device 200 of FIGS. 2-6 could be extended in second direction 204 and/or in third direction 206 to include one or more winding windows and an associated winding set for each additional window. For instance, FIGS. 32-36 illustrate a magnetic device 3200, which is an alternate embodiment of magnetic device 200 extended in third direction 206 to include additional winding windows and associated winding sets. FIG. 32 is a top plan view of magnetic device 3200, FIG. 33 is a front elevational view of magnetic device 3200, FIG. 34 is a side elevational view of magnetic device 3200, FIG. 35 is a bottom plan view of magnetic device 3200, and FIG. 36 is a cross-sectional view of magnetic device 3200 taken along line 36A-36A of FIG. 32.

Magnetic device 3200 differs from magnetic device 200 in that (i) magnetic device 3200 includes a magnetic core 3208 in place of magnetic core 208, (ii) magnetic device 3200 further includes a third primary winding 3244 and a fourth primary winding 3246, and (ii) magnetic device 3200 further includes a third secondary winding 3248 and a fourth secondary winding 3250. Magnetic core 3208 differs from magnetic core 208 in that magnetic core 3208 is wider in third direction 206 and magnetic core 3208 forms two additional winding windows, i.e., a third winding window 3252 and a fourth winding window 3254. Each of third winding window 3252 and fourth winding window 3254 extends through magnetic core 3208 in first direction 202. Magnetic core 3208 includes a top outer surface 3238, a bottom outer surface 3240, and a front outer surface 3242 in place of top outer surface 238, bottom outer surface 240, and front outer surface 242, respectively. Each of third primary winding 3244 and fourth primary winding 3246 is an embodiment of a primary winding 114 of FIG. 1, and each of third secondary winding 3248 and fourth secondary winding 3250 is an embodiment of a secondary winding 116 of FIG. 1. Third primary winding 3244 has opposing ends 3256 and 3258, and fourth primary winding 3246 has opposing ends 3260 and 3262. Third secondary winding 3248 has opposing ends 3264 and 3266, and fourth secondary winding 3250 has opposing ends 3268 and 3270.

Third primary winding 3244 is wound through third winding window 3252 and around a portion of magnetic core 3208 such that (i) end 3256 of third primary winding 3244 is on top outer surface 3238 of magnetic core 3208 and (ii) end 3258 of third primary winding 3244 is on bottom outer surface 3240 of magnetic core 3208. Similarly, fourth primary winding 3246 is wound through fourth winding window 3254 and around a portion of magnetic core 3208 that (i) end 3260 of fourth primary winding 3246 is on top outer surface 3238 of magnetic core 3208 and (ii) end 3262 of fourth primary winding 3246 is on bottom outer surface 3240 of magnetic core 3208. Third secondary winding 3248 is wound through third winding window 3252, along bottom outer surface 3240 of magnetic core 3208, and along a back outer surface 3272 of magnetic core 3208 such that end 3264 and end 3266 of third secondary winding 3248 are each on top outer surface 3238 of magnetic core 3208. Additionally, fourth secondary winding 3250 is wound through fourth winding window 3254, along bottom outer surface 3240 of magnetic core 3208, and along back outer surface 3272 of magnetic core 3208 such that end 3268 and end 3270 of fourth secondary winding 3250 are each on top outer surface 3238 of magnetic core 3208.

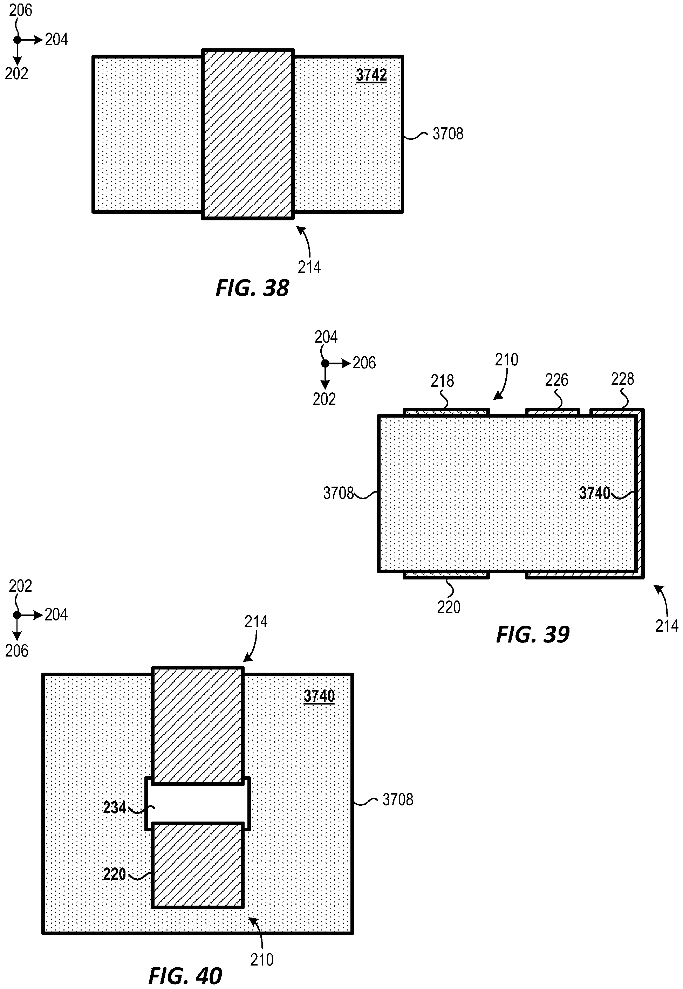

Any of the above-discussed magnetic devices could also be modified to include only a single winding set. For example, FIGS. 37-40 illustrate a magnetic device 3700, which is an alternate embodiment of magnetic device 200 (FIGS. 2-6) modified to include only a single winding set. FIG. 37 is a top plan view of magnetic device 3700, FIG. 38 is a front elevational view of magnetic device 3700, FIG. 39 is a side elevational view of magnetic device 3700, and FIG. 40 is a bottom plan view of magnetic device 3700. Magnetic device 3700 differs from magnetic device 200 in that (i) magnetic core 208 is replaced with a magnetic core 3708, (ii) second primary winding 212 is omitted, and (iii) secondary winding 216 is omitted. Magnetic core 3708 includes a top outer surface 3738, a bottom outer surface 3740, and front outer surface 3742 in place of top outer surface 238, bottom outer surface 240, and front outer surface 242, respectively. First primary winding 210 is henceforth referred to as "primary winding 210" instead of "first primary winding 210" in the context of magnetic device 3700 because magnetic device 3700 includes only one primary winding. Similarly, first secondary winding 214 is henceforth referred to as "secondary winding 214" instead of "first secondary winding 214" in the context of magnetic device 3700 because magnetic device 3700 includes only one secondary winding.

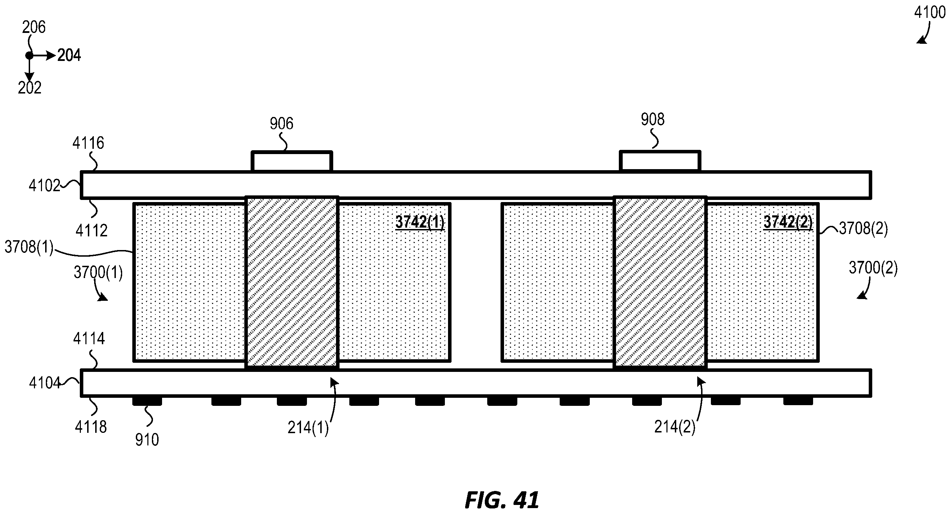

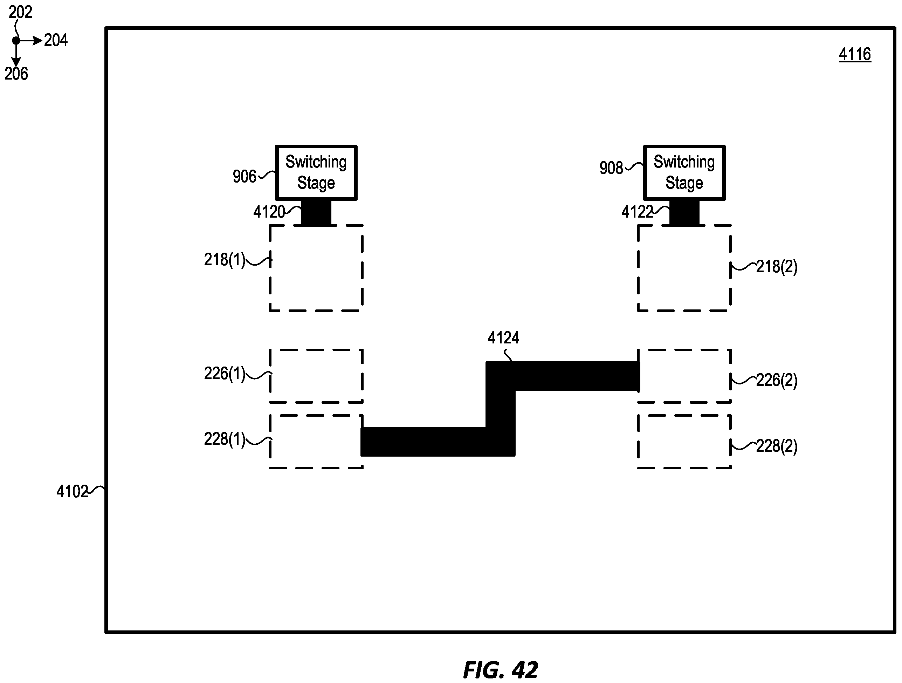

An electrical assembly may include multiple instances of magnetic device 3700 to support multiple phases, such as a respective instance of magnetic device 3700 for each phase of a multi-phase switching power converter. For example, FIGS. 41 and 42 illustrate an electrical assembly 4100, where electrical assembly 4100 is an alternate embodiment of electrical assembly 900 (FIGS. 9-11) including two instances of magnetic device 3700 in place of magnetic device 200 (FIGS. 2-6). FIG. 41 is a front elevational view of electrical assembly 4100, and FIG. 42 is a top plan view of electrical assembly 4100. Only one instance of capacitors 910 is labeled in FIG. 41. Electrical assembly 4100 differs from electrical assembly 900 in that (i) magnetic device 200 is replaced with two instance of magnetic device 3700, i.e., magnetic devices 3700(1) and 3700(2), (ii) first substrate 902 is replaced with a first substrate 4102, and (iii) second substrate 904 is replaced with a second substrate 4104. First substrate 4102 is similar to, but larger than, first substrate 902, and second substrate 4104 is similar to, but larger than, second substrate 904. First substrate 4102 includes a bottom surface 4112 and top surface 4116, and second substrate 4104 includes a bottom surface 4118 and a top surface 4114.

First substrate 4102 and second substrate 4104 are separated from each other in first direction 202, and each magnetic device 3700 is disposed between first substrate 4102 and second substrate 4104 in first direction 202. Magnetic devices 3700 are separated from each other in second direction 204, and in some alternate embodiments, magnetic devices 3700 are separated from each other in third direction 206, in place of, or in addition to, being separated from each other in second direction 204. Ends 218 of primary windings 210, ends 226 of secondary windings 214, and ends 228 of secondary windings 214 are connected to bottom surface 4112 of first substrate 4102 by surface mount soldering. Ends 220 of primary windings 210 are connected to top surface 4114 of second substrate 4104. In some alternate embodiments, the winding ends are connected to first substrate 4102 and/or second substrate 4104 by a method other than surface mount soldering, such as by through-hole pins soldered into plated through-holes in the substrates.

FIG. 42 illustrates in dashed lines outlines of winding ends that connect to bottom surface 4112 of first substate 4102. Each of first switching stage 906 and second switching stage 908 is on first substrate 4102. First switching stage 906 is electrically coupled 4120 to end 218(1) of primary winding 210(1) of magnetic device 3700(1), and second switching stage 908 is electrically coupled 4122 to end 218(2) of primary winding 210(2) of magnetic device 3700(2). An electrical conductor 4124 of first substrate 4102 electrically couples end 228(1) of secondary winding 214(1) of magnetic device 3700(1) to end 226(2) of secondary winding 214(2) of magnetic device 3700(2), thereby coupling secondary winding 214(1) and secondary winding 214(2) in series. Electrical conductor 4124 includes, for example, a PCB trace or a PCB conductive polygon.

In particular embodiments, magnetic device 3700(1), magnetic device 3700(2), first switching stage 906, second switching stage 908, and capacitors 910 of electrical assembly 4100 form part of a multi-phase switching power converter. For example, in some embodiments, the aforementioned elements of electrical assembly 4100 form a multi-phase switching power converter similar to multi-phase switching power converter 1200 of FIG. 12 where (i) primary winding 210(1) of magnetic device 3700(1) is electrically coupled between switching node X(1) and output power node 1212, (ii) primary winding 210(2) of magnetic device 3700(2) is electrically coupled between switching node X(2) and output power node 1212, and (iii) secondary winding 214(1) of magnetic device 3700(1) and secondary winding 214(2) of magnetic device 3700(2) are electrically coupled in series with tuning inductor 1204.

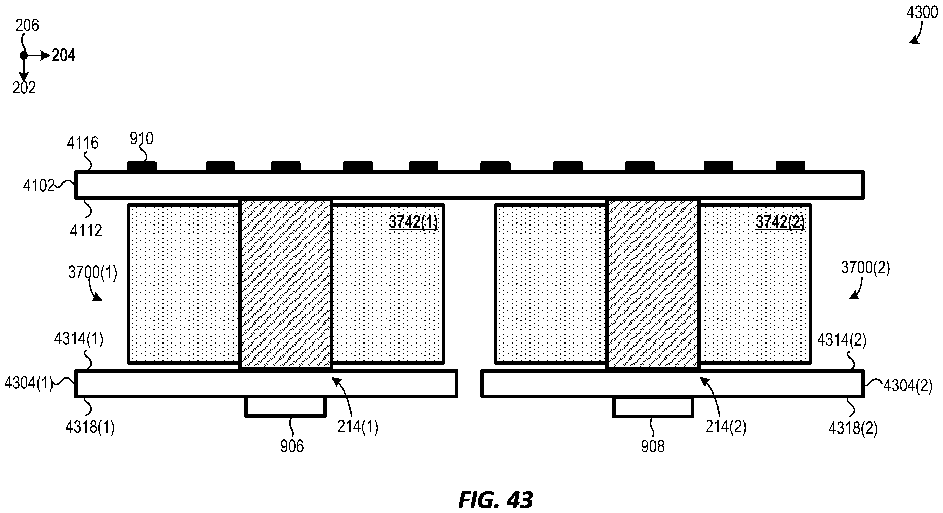

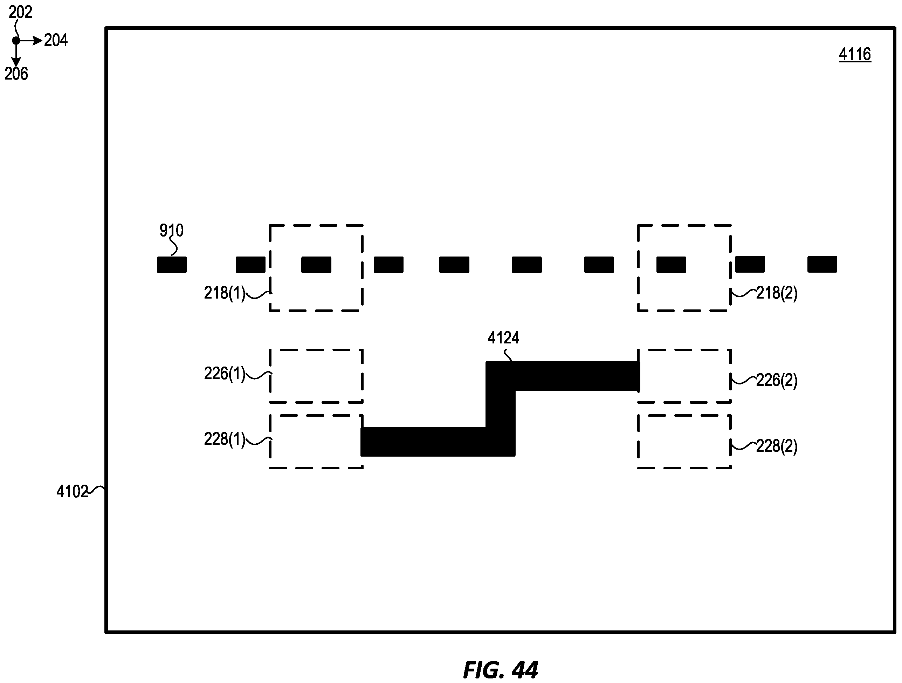

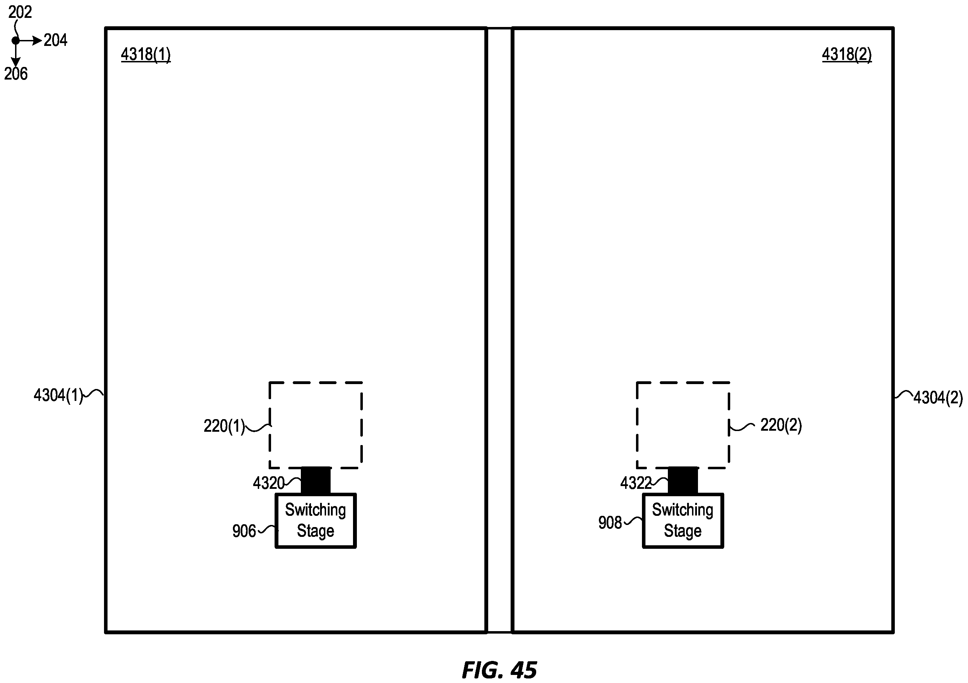

FIGS. 43-45 illustrate an electrical assembly 4300, which is an alternate embodiment of electrical assembly 4100 (FIGS. 41 and 42) where second substrate 4104 is replaced with a respective additional substrate 4304 for each magnetic device 3700, and where each additional substrate 4304 includes a top surface 4314 and a bottom surface 4318. First substrate 4102 remains as a common substrate for each magnetic device 3700 in electrical assembly 4300. FIG. 43 is a front elevational view of electrical assembly 4300, FIG. 44 is a top plan view of electrical assembly 4300, and FIG. 45 is a bottom plan view of electrical assembly 4300. Electrical assembly 4300 additionally differs from electrical assembly 4100 in that (i) first switching stage 906 is located on first additional substrate 4304(1) instead of on first substrate 4102, (ii) second switching stage 908 is located on second additional substrate 4304(2) instead of on first substrate 4102, and (iii) capacitors 910 are located on substrate 902 instead of on second substrate 4104. Only one instance of capacitors 910 is labeled in each of FIGS. 43 and 44. First switching stage 906 is electrically coupled 4320 to end 220(1) of primary winding 210(1) of magnetic device 3700(1) on additional substrate 4304(1), as illustrated in FIG. 45. Additionally, second switching stage 908 is electrically coupled 4322 to end 220(2) of primary winding 210(2) of magnetic device 3700(2) on additional substrate 4304(2), as also illustrated in FIG. 45.

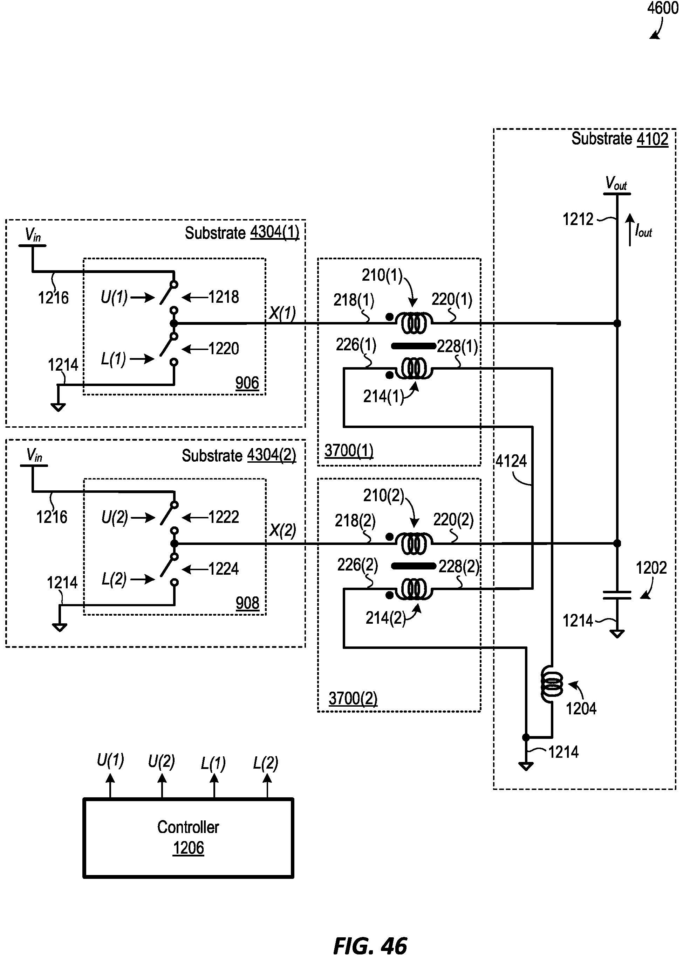

FIG. 46 is an electrical schematic diagram of a multi-phase switching power converter 4600 at least partially formed by elements of electrical assembly 4300 (FIGS. 43-45). It is understood, though, that electrical assembly 4300 is not limited to forming the FIG. 46 multi-phase switching power converter. Multi-phase switching power converter 4600 is similar to multi-phase switching power converter 1200 of FIG. 12 except that multi-phase switching power 4400 includes two instances of magnetic device 3700, i.e., magnetic device 3700(1) and 3700(2), in place of magnetic device 200. Additionally, the arrangement of elements among substrates differs between multi-phase switching power converter 4400 and multi-phase switching power converter 1200. For example, first switching stage 906 and second switching stage 908 are located on respective additional substrates 4304(1) and 4304(1), instead of on common substrate 902, in multi-phase switching power converter 4600. As another example, tuning inductor 1204 (not shown in FIGS. 43-45) is located on first substrate 4102 in multi-phase switching power converter 4600.

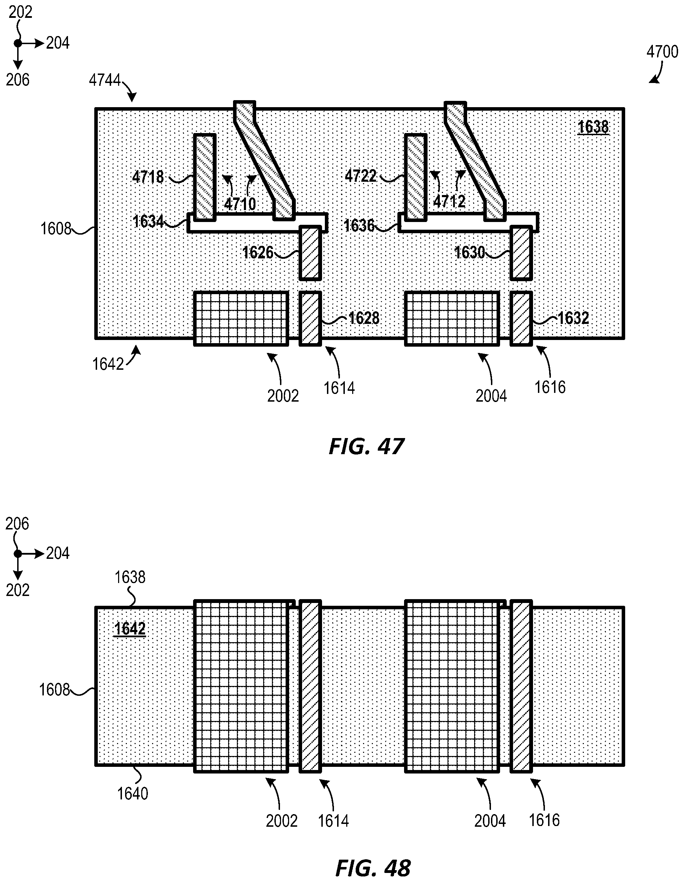

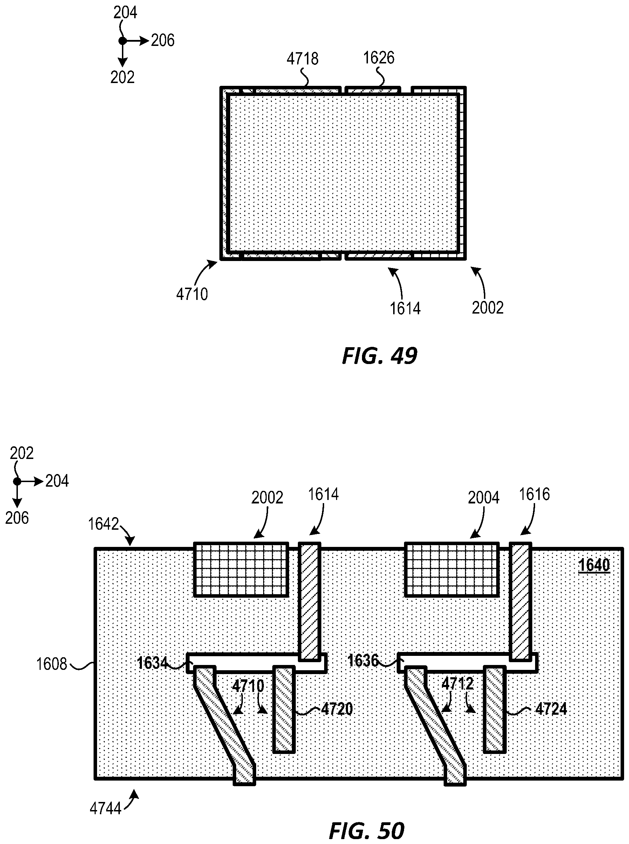

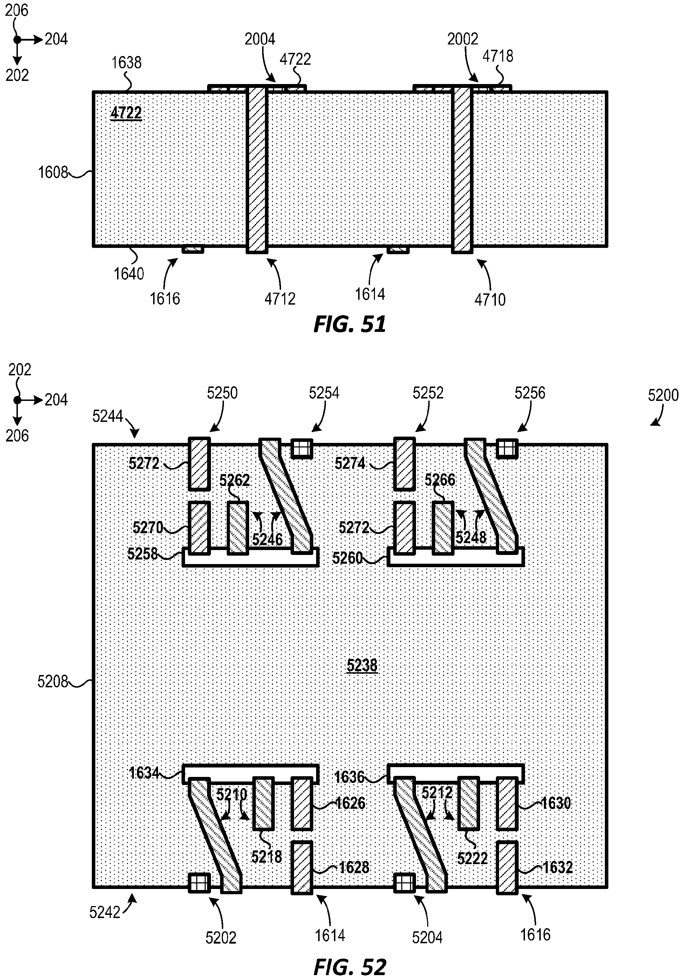

The primary winding and the secondary winding of a given winding set form a common number of turns, such that a turns ratio is 1:1, in the example magnetic devices discussed above. However, any of the magnetic device disclosed herein could be modified so that the primary winding and the secondary winding of a given winding set form different respective numbers of turns, to obtain a turns ratio other than 1:1. For example, FIGS. 47-51 illustrate a magnetic device 4700, which is an alternate embodiment of magnetic device 2000 (FIGS. 20-24) with primary windings forming two turns each. FIG. 47 is a top plan view of magnetic device 4700, FIG. 48 is a front elevational view of magnetic device 4700, FIG. 49 is a side elevational view of magnetic device 4700, FIG. 50 is a bottom plan view of magnetic device 4700, and FIG. 51 is a back elevational view of magnetic device 4700.

Magnetic device 4700 differs from magnetic device 2000 in that (i) first primary winding 210 is replaced with a first primary winding 4710 and (i) second primary winding 212 is replaced with a second primary winding 4712. First primary winding 4710 is wound along a back outer surface 4744 of magnetic core 1608 and through first winding window 1634 to form two turns, and first primary winding 4710 has opposing ends 4718 and 4720. End 4718 is analogous to end 218 of first primary winding 210, and end 4718 is accordingly on top outer surface 1638 of magnetic core 1608. End 4720 is analogous to end 220 of first primary winding 210, and end 4720 is accordingly on bottom outer surface 1640 of magnetic core 1608. Similarly, second primary winding 4712 is wound along back outer surface 4744 of magnetic core 1608 and through second winding window 1636 to form two turns, and second primary winding 4712 has opposing ends 4722 and 4724. End 4722 is analogous to end 222 of second primary winding 212, and end 4722 is accordingly on top outer surface 1638 of magnetic core 1608. End 4724 is analogous to end 224 of second primary winding 210, and end 4724 is accordingly on bottom outer surface 1640 of magnetic core 1608.

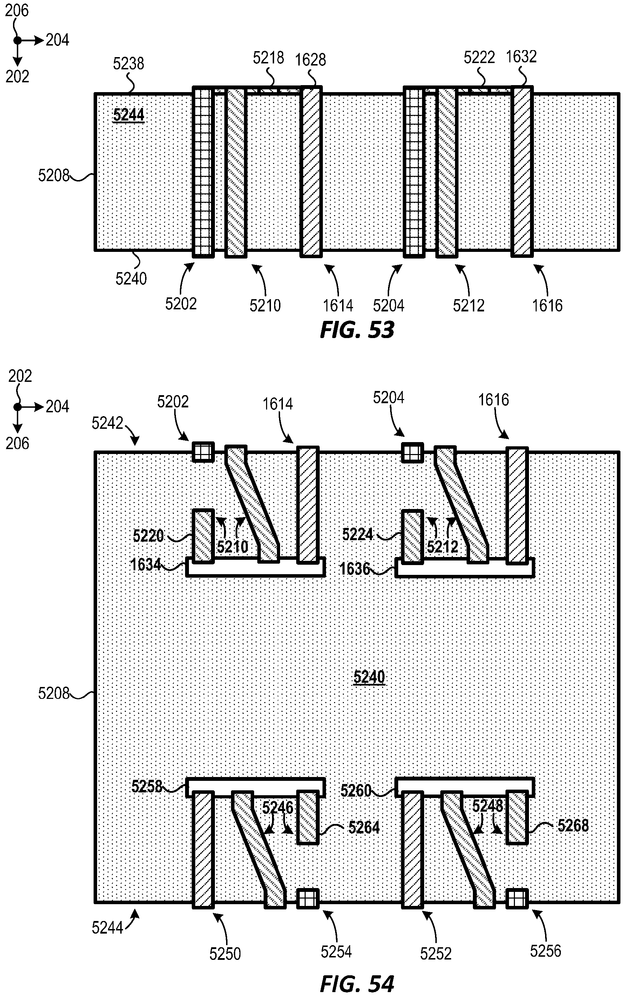

Magnetic device 4700 is scalable in second direction 204, or stated differently, magnetic device 4700 could be modified by extending magnetic core 1608 in second direction 204 and adding one or more winding windows and associated winding sets that are separated from each other in second direction 204. However, magnetic device 4700 is not scalable in third direction 206 due to windings being wound around both front outer surface 1642 of magnetic core 1608 and back outer surface 4744 of magnetic core 1608. FIGS. 52-54 illustrate a magnetic device 5200 which is an alternate embodiment of magnetic device 4700 (FIGS. 47-51) that is scalable in third direction 206 as well as in second direction 204. FIG. 52 is a top plan view of magnetic device 5200, FIG. 53 is a front elevational view of magnetic device 5200, and FIG. 54 is a bottom plan view of magnetic device 5200.

Magnetic device 5200 differs from magnetic device 4700 in that (i) magnetic core 1608 is replaced with a magnetic core 5208, (ii) first primary winding 4710 and second primary winding 4712 are replaced with a first primary winding 5210 and a second primary winding 5212, respectively, (iii) magnetic device 5200 further includes a third primary winding 5246 and a fourth primary winding 5248, (iv) magnetic device 5200 further includes a third secondary winding 5250 and a fourth secondary winding 5252, and (v) magnetic device 5200 further include a third ground conductor 5254 and a fourth ground conductor 5256. Magnetic core 5208 includes a top outer surface 5238, a bottom outer surface 5240, a front outer surface 5242, and a back outer surface 5244 in place of top outer surface 1638, bottom outer surface 1640, front outer surface 1642, and back outer surface 4744, respectively.

Magnetic core 5208 forms a third winding window 5258 and a fourth winding window 5260 each extending through first magnetic core 5208 in first direction 202, in addition to first winding window 1634 and second winding window 1636. Each of first ground conductor 5202 and second ground conductor 5204 extends along front outer surface 5242 of magnetic core 5208, and each of first ground conductor 5202 and second ground conductor 5204 wraps around magnetic core 5208 to extend over each of top outer surface 5238 of magnetic core 5208 and bottom outer surface 5240 of magnetic core 5208. Each of third ground conductor 5254 and fourth ground conductor 5256 extends along back outer surface 5244 of magnetic core 5208, and each of third ground conductor 5254 and fourth ground conductor 5256 wraps around magnetic core 5208 to extend over each of top outer surface 5238 of magnetic core 5208 and bottom outer surface 5240 of magnetic core 5208.

First primary winding 5210 is wound along front outer surface 5242 of magnetic core 528 and through first winding window 1634 to form two turns, and first primary winding 5210 has opposing ends 5218 and 5220. End 5218 is analogous to end 218 of first primary winding 210, and end 5218 is accordingly on top outer surface 5238 of magnetic core 5208. End 5220 is analogous to end 220 of first primary winding 210, and end 5220 is accordingly on bottom outer surface 5240 of magnetic core 5208. Similarly, second primary winding 5212 is wound along front outer surface 5242 of magnetic core 5208 and through second winding window 1636 to form two turns, and second primary winding 5212 has opposing ends 5222 and 5224. End 5222 is analogous to end 222 of second primary winding 212, and end 5222 is accordingly on top outer surface 5238 of magnetic core 5208. End 5224 is analogous to end 224 of second primary winding 210, and end 5224 is accordingly on bottom outer surface 5240 of magnetic core 5208. Third primary winding 5246 has opposing ends 5262 and 5264. Third primary winding 5246 is analogous to first primary winding 5210, but (i) third primary winding 5246 is wound through third winding window 5258 instead of through first winding window 1634, and (ii) third primary winding 5246 is wound along back outer surface 5244 instead of along front outer surface 5242. Fourth primary winding 5248 has opposing ends 5266 and 5268. Fourth primary winding 5248 is analogous to second primary winding 5212, but (i) fourth primary winding 5248 is wound through fourth winding window 5260 instead of through second winding window 1636, and (ii) fourth primary winding 5248 is wound along back outer surface 5244 instead of along front outer surface 5242.

Third secondary winding 5250 has opposing ends 5270 and 5272 on top outer surface 5238 of magnetic core 5208. Third secondary winding 5250 is analogous to first secondary winding 1614 but (i) third second winding 5250 is wound through third winding window 5258 instead of through first winding window 1634, and (ii) third secondary winding 5250 is wound along back outer surface 5244 instead of along front outer surface 5242. Fourth secondary winding 5252 has opposing ends 5272 and 5274 on top outer surface 5238 of magnetic core 5208. Fourth secondary winding 5252 is analogous to second secondary winding 1616, but (i) fourth secondary winding 5252 is wound through fourth winding window 5260 instead of through second winding window 1636, and (ii) fourth secondary winding 5252 is wound along back outer surface 5244 instead of along front outer surface 5242.

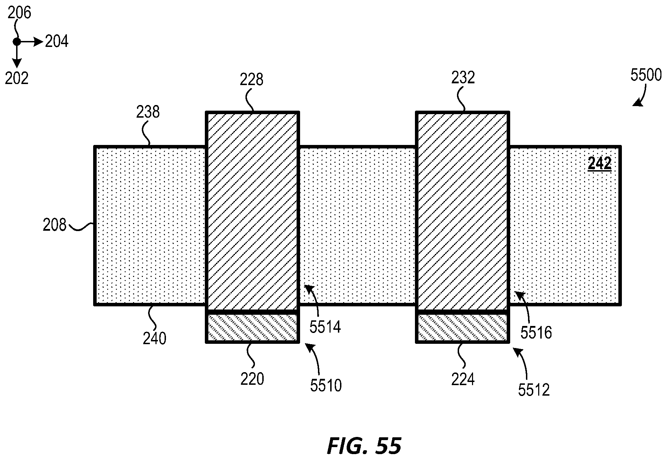

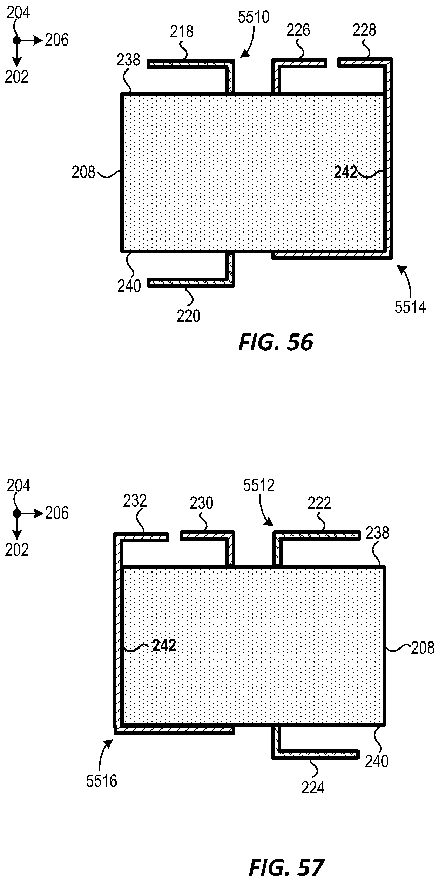

Winding ends are disposed on magnetic core outer surfaces in the above-discussed examples, such as to promote low profile of the magnetic devices. However, any of the magnetic devices disclosed herein could be modified so that one or more winding ends are offset from an adjacent magnetic core outer surface, such as to provide room for components between the magnetic device and adjacent substrates. For example, FIGS. 55-57 illustrate a magnetic device 5500, which is an alternate embodiment of magnetic device 200 (FIGS. 2-6) where winding ends are offset from magnetic core outer surfaces. FIG. 55 is a front elevational view of magnetic device 5500, FIG. 56 is a side elevational view of magnetic device 5500, and FIG. 57 is a side elevational view of magnetic device 5500 that is opposite the side elevational view of FIG. 56.

Magnetic device 5500 differs from magnetic device 200 in that (i) first primary winding 210 is replaced with a first primary winding 5510, (ii) second primary winding 212 is replaced with a second primary winding 5512, (iii) first secondary winding 214 is replaced with a first secondary winding 5514, and (iv) second secondary winding 216 is replaced with a second secondary winding 5516. First primary winding 5510 differs from first primary winding 210 in that ends 218 and 220 are offset from magnetic core outer surfaces 238 and 240, respectively, in first direction 202. Similarly, second primary winding 5512 differs from second primary winding 212 in that ends 222 and 224 are offset from magnetic core outer surfaces 238 and 240, respectively, in first direction 202. First secondary winding 5514 differs from first secondary winding 214 in that ends 226 and 228 are offset from magnetic core outer surface 238 in first direction 202, and second secondary winding 5516 differs from second secondary winding 216 in that ends 230 and 232 are offset from magnetic core outer surface 238 in first direction 202.

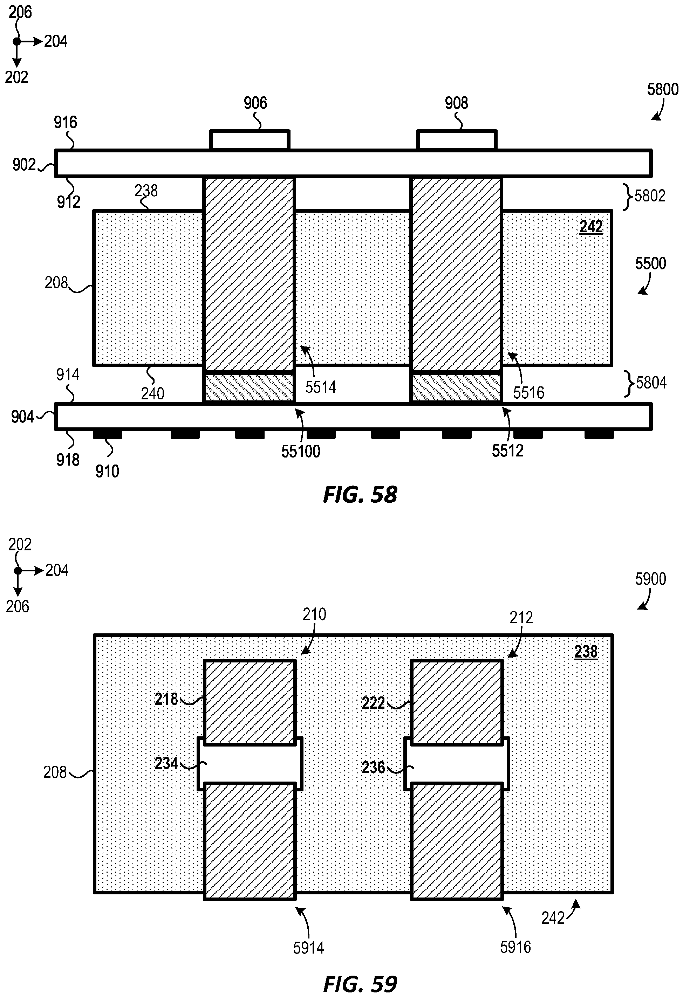

FIG. 58 is a front elevational view of an electrical assembly 5800, which is an alternate embodiment of electrical assembly 900 (FIGS. 9-11) where magnetic device 200 (FIGS. 2-6) is replaced with magnetic device 5500 (FIGS. 55-57). It should be noted that the fact that winding ends are offset from magnetic core outer surfaces leaves space 5802 between magnetic core 208 and first substrate 902, as well as space 5804 between magnetic core 208 and second substrate 904, for locating additional components (not shown) of electrical assembly 5800.

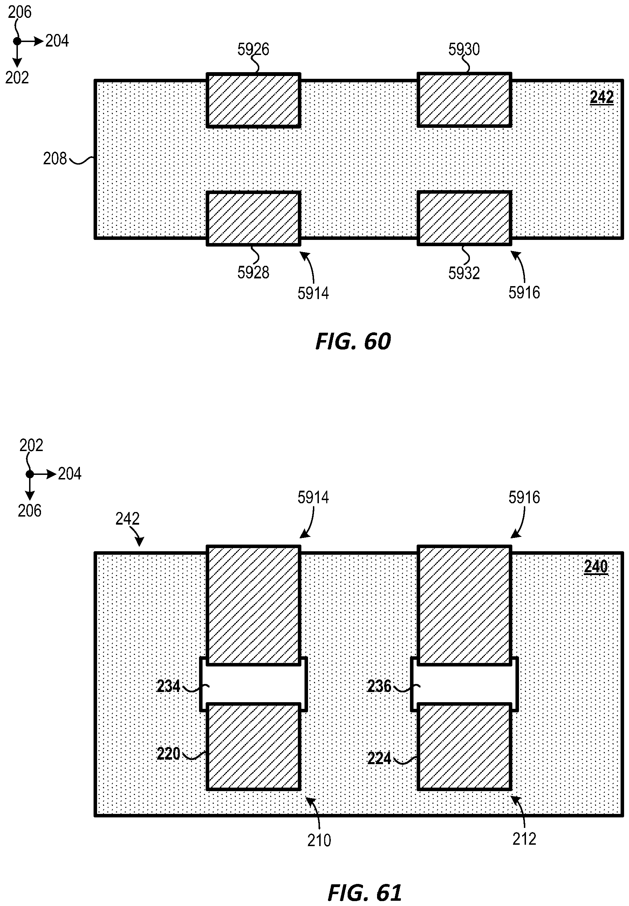

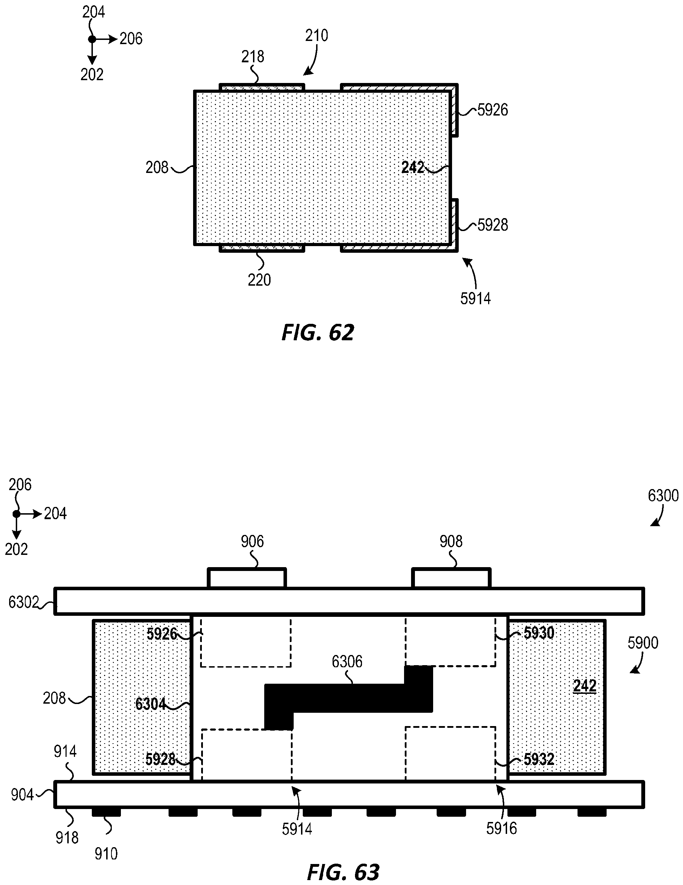

The secondary windings in the above discussed magnetic devices could be modified so that the secondary winding ends terminate on a magnetic core outer surface other than a top outer surface or a bottom outer surface. For example, FIGS. 59-62 illustrate a magnetic device 5900 which is an alternate embodiment of magnetic device 200 (FIGS. 2-6) where secondary windings terminate on front outer surface 242 of magnetic core 208 instead of on top outer surface 238 of magnetic core 208. FIG. 59 is a top plan view of magnetic device 5900, FIG. 60 is a front elevational view of magnetic device 5900, FIG. 61 is a bottom plan view of magnetic device 5900, and FIG. 62 is a side elevational view of magnetic device 5900. Magnetic device 5900 differs from magnetic device 200 in that first secondary winding 214 and second secondary winding 216 are replaced with a first secondary winding 5914 and a second secondary winding 5916, respectively. First secondary winding 5914 has opposing ends 5926 and 5928 that are analogous to ends 226 and 228 of first secondary winding 214, respectively, and second secondary winding 5916 has opposing ends 5930 and 5932 that are analogous to ends 230 and 232 of second secondary winding 216, respectively. Each of ends 5926, 5928, 5930, and 5932 is on outer surface 242 of magnetic core 208.

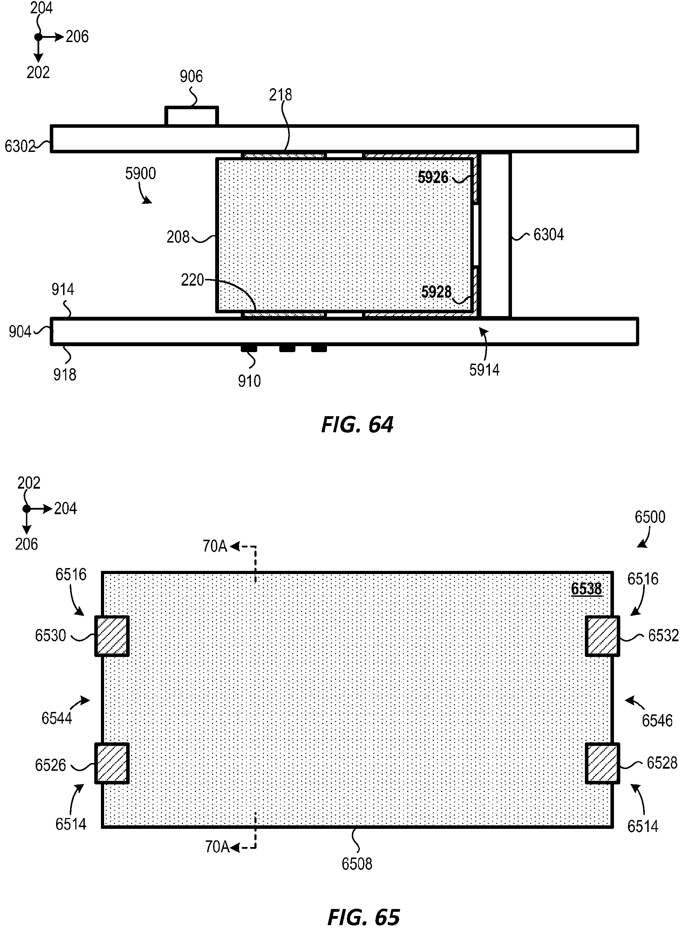

FIG. 63 is a front elevational view of an electrical assembly 6300, which is an alternate embodiment of electrical assembly 900 (FIGS. 9-11) where (i) magnetic device 200 is replaced with magnetic device 5900, (ii) first substrate 902 is replaced with a first substrate 6302, and (iii) electrical assembly 6300 further includes a third substrate 6304. FIG. 64 is a side elevational view of electrical assembly 6300. Third substrate 6304 is placed over winding ends 5926, 5928, 5930, and 5932 is third direction 206. FIG. 63 illustrates in dashed lines outlines of winding ends 5926, 5928, 5930, and 5932 that are covered by third substrate 6304 in the FIG. 63 elevational view. First substrate 6302 is similar to first substrate 902 of electrical assembly 900, but first substrate 6302 does not electrically couple secondary windings in series. Instead, third substrate 6304 includes an electrical conductor 6306 electrically coupling end 5928 of first secondary winding 5914 to end 5930 of second secondary winding 5916, such that first secondary winding 5914 and second secondary winding 5916 are electrically coupled in series. Third substrate 6304 optionally also includes one or more additional electrical conductors (not shown), such as to route one or more signals between first substrate 6302 and second substrate 904.

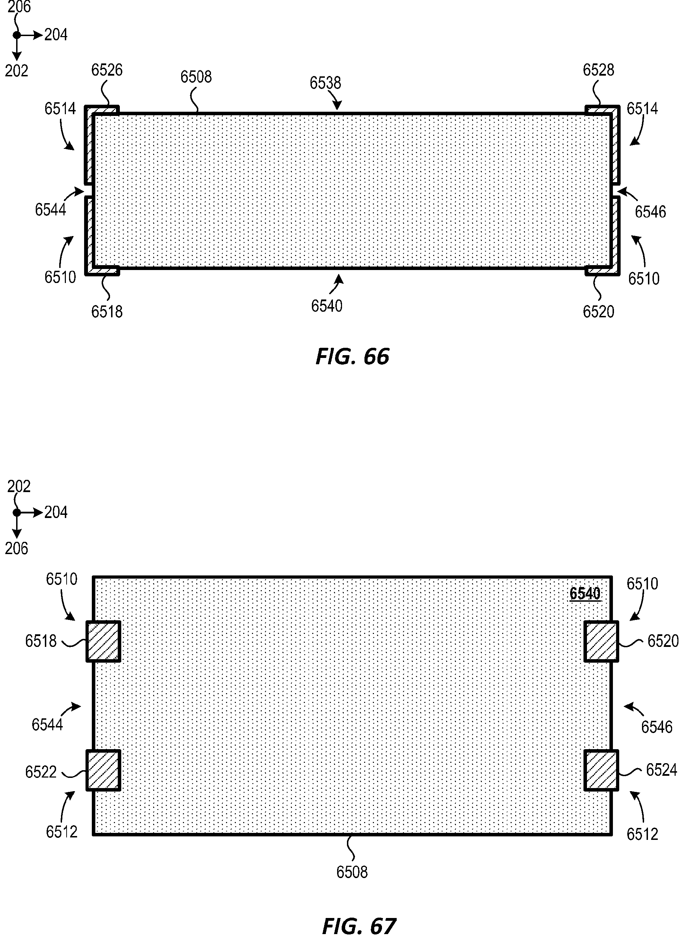

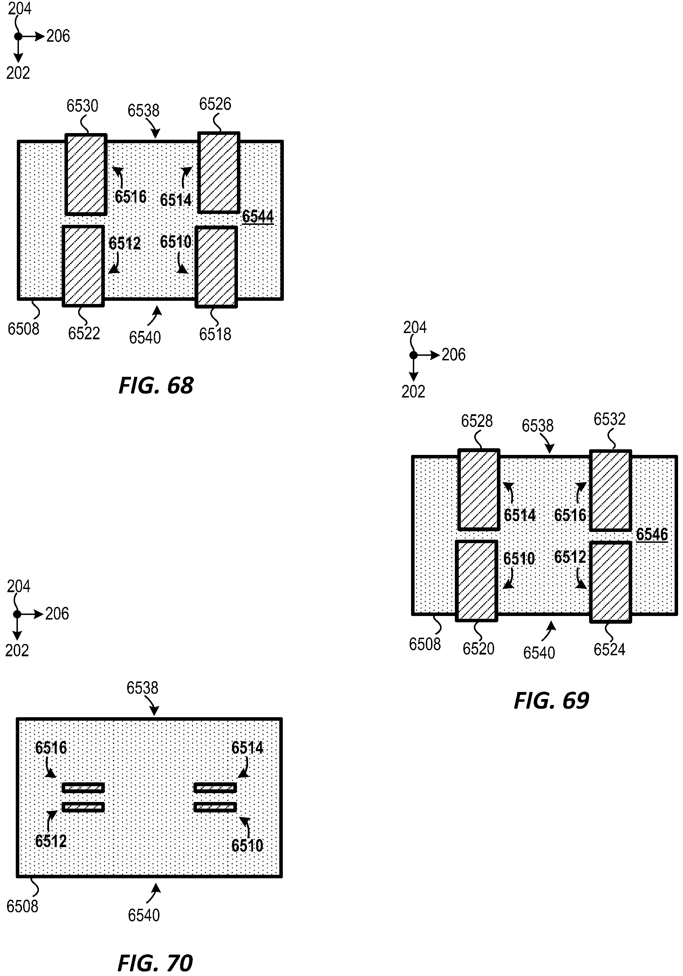

Additionally, the magnetic devices discussed above could be modified so that primary winding ends terminate on a common outer surface of a magnetic core. For example, FIGS. 65-70 illustrate a magnetic device 6500 where primary windings terminate on one magnetic core outer surface and secondary windings terminate on an opposing magnetic core outer surface. FIG. 65 is a top plan view of a magnetic device 6500, FIG. 66 is a front elevational view of magnetic device 6500, FIG. 67 is a bottom plan view of magnetic device 6500, FIG. 68 is a side elevational view of magnetic device 6500, FIG. 69 is a side elevational view of magnetic 6500 of opposite of the side elevational view of magnetic device 6500 of FIG. 68, and FIG. 70 is a cross-sectional view of magnetic device 6500 taken along line 70A-70A of FIG. 65. Magnetic device 6500 includes a magnetic core 6508, a first primary winding 6510, a second primary winding 6512, a first secondary winding 6514, and second secondary winding 6516. First primary winding 6510 is magnetically coupled with first secondary winding 6514, and second primary winding 6512 is magnetically coupled with second secondary winding 6516. First primary winding 6510 is ideally not magnetically coupled with second primary winding 6512, but there will typically be some magnetic coupling of first primary winding 6510 and second primary winding 6512 due to the two windings sharing common magnetic core 6508.

It is understood that the quantity of windings in magnetic device 6500 may vary, though, as long as magnetic device 6500 includes at least one primary winding and associated secondary winding. For example, magnetic device 6500 could be modified by omitting second primary winding 6512 and second secondary winding 6516. As another example, magnetic device 6500 could be modified to include one or more winding sets, where each winding set includes a respective primary winding and a respective secondary winding that are magnetically coupled with each other.

First primary winding 6510 has opposing ends 6518 and 6520. First primary winding 6510 extends through magnetic core 6508 in second direction 204. First primary winding 6510 wraps around a side outer surface 6544 of magnetic core 6508 and onto a bottom outer surface 6540 of magnetic core 6508 such that end 6518 is bottom outer surface 6540. Additionally, first primary winding 6510 wraps around a side outer surface 6546 of magnetic core 6508, where side outer surface 6546 is opposite of side outer surface 6544, and onto bottom outer surface 6540 of magnetic core 6508 such that end 6520 is on bottom outer surface 6540. Second primary winding has opposing ends 6522 and 6524. Second primary winding 6512 is configured similarly to first primary winding 6510, but second primary winding 6512 is displaced from first primary winding 6510 in third direction 206. Accordingly, each of end 6522 and end 6524 of second primary winding 6512 is on second outer surface 6540 of magnetic core 6508.

First secondary winding 6514 has opposing ends 6526 and 6528. First secondary winding 6514 extends through magnetic core 6508 in second direction 204. First secondary winding 6514 wraps around side outer surface 6544 of magnetic core 6508 and onto a top outer surface 6538 of magnetic core 6508 such that end 6526 is on top outer surface 6538. Additionally, first secondary winding 6514 wraps around side outer surface 6546 of magnetic core 6508 and onto top outer surface 6538 of magnetic core 6508 such that end 6528 is on top outer surface 6538. Second secondary winding 6516 has opposing ends 6530 and 6532. Second secondary winding 6516 is configured similarly to first secondary winding 6514, but second secondary winding 6516 is displaced from first secondary winding 6514 in third direction 206. Accordingly, each of end 6530 and end 6532 of second secondary winding 6516 is on top outer surface 6538 of magnetic core 6508. First secondary winding 6514 is disposed over first primary winding 6510 is first direction 202, and second secondary winding 6516 is disposed over second primary winding 6512 in first direction 202. Although FIGS. 65-70 illustrate magnetic device 6500 as being a monolithic element, magnetic device 6500 could be formed by joining two or more elements. For example, in some embodiment, magnetic device 6500 is formed by stacking two elements in first direction 202, where each element includes a magnetic core and two windings.

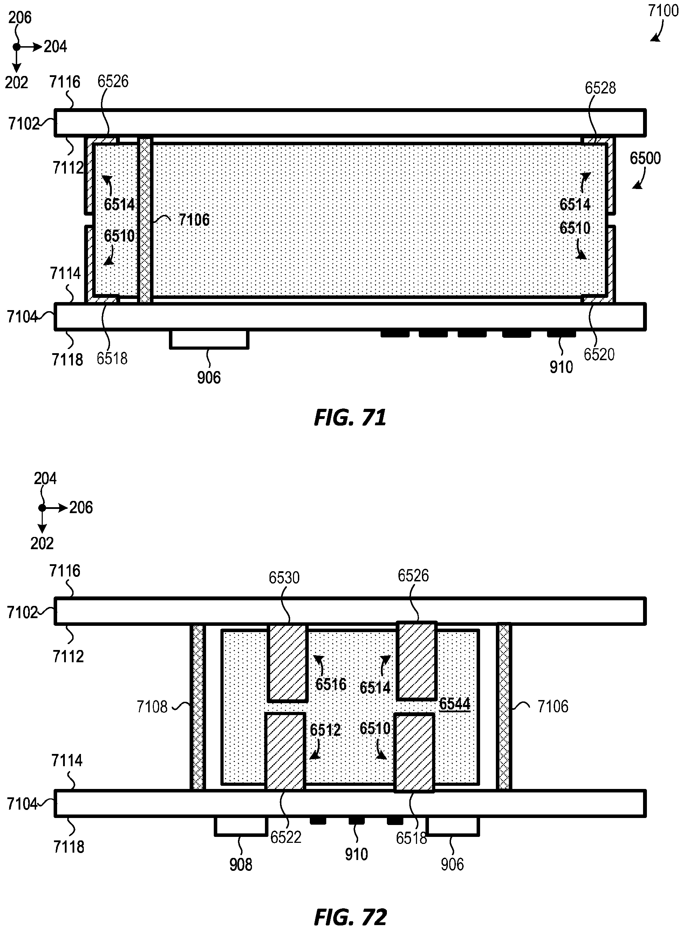

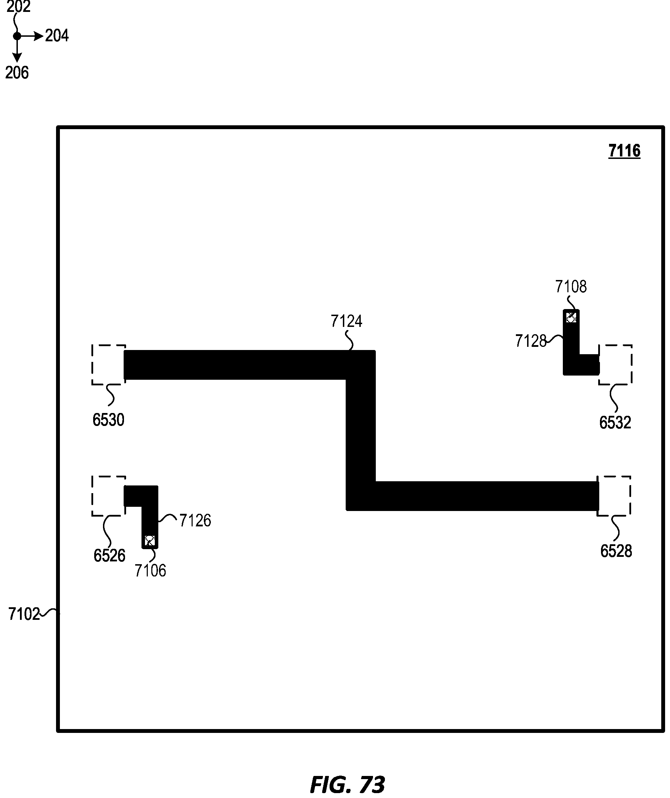

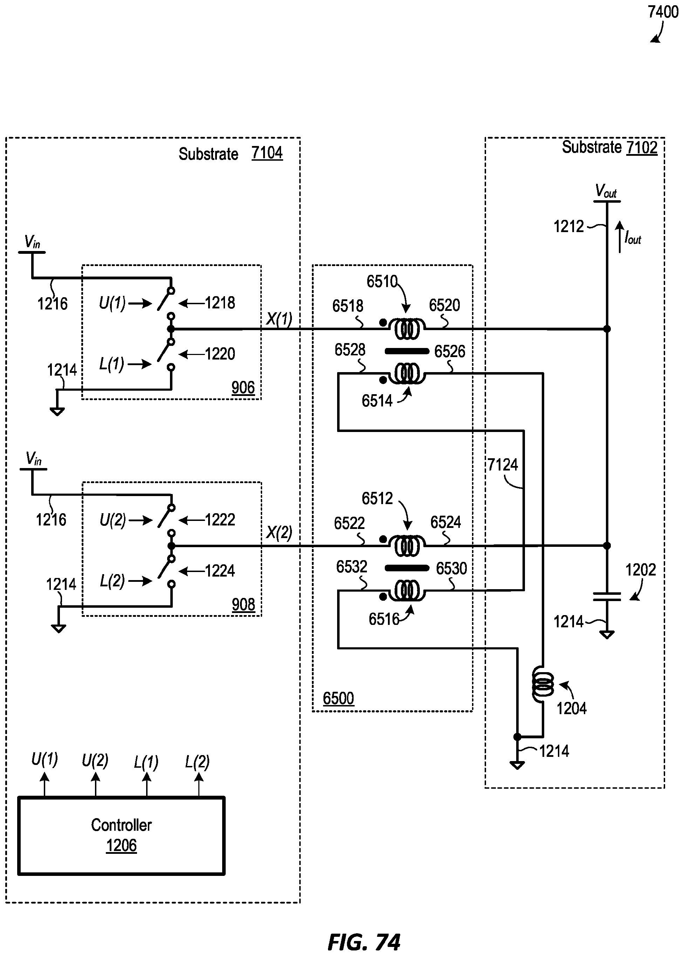

FIGS. 71-73 illustrate an electrical assembly 7100, where electrical assembly 7100 is one embodiment of an electrical assembly including an instance of magnetic device 6500 (FIGS. 65-70). FIG. 71 is a front elevational view of electrical assembly 7100, FIG. 72 is a side elevational view of electrical assembly 7100, and FIG. 73 is a top plan view of electrical assembly 7100. Electrical assembly 7100 includes a first substrate 7102, a second substrate 7104, an instance of magnetic device 6500, an instance of first switching stage 906 (discussed above with respect to FIGS. 9-12), an instance of second switching stage 908 (discussed above with respect to FIGS. 9-12, a plurality of capacitors 910, a first pin 7106, and a second pin 7108. Only one capacitor 910 instance is labeled in FIGS. 71 and 72. Electrical assembly 7100 may include additional elements, such as discussed below with respect to FIG. 74, without departing from the scope hereof.

First substrate 7102 and second substrate 7104 are separated from each other in first direction 202, and magnetic device 6500 is disposed between first substrate 7102 and second substrate 7104 in first direction 202. In some embodiments, each of first substrate 7102 and second substrate 7104 is a respective PCB. End 6518 of first primary winding 6510, end 6520 of first primary winding 6510, end 6522 of second primary winding 6512, and end 6524 of second primary winding 6512 are connected to a top surface 7114 of second substrate 7104 by surface mount soldering. End 6526 of first secondary winding 6514, end 6528 of first secondary winding 6514, end 6530 of second secondary winding 6516, and end 6532 of second secondary winding 6516 are connected to a bottom surface 7112 of first substrate 7102 by surface mount soldering. In some alternate embodiments, the winding ends are connected to first substrate 7102 and/or second substrate 7104 by a method other than surface mount soldering, such as by through-hole pins soldered into plated through-holes in the substrates.

Each of first pin 7106 and second pin 7108 is disposed between first substrate 7102 and second substrate 7104 in first direction 202. Each of first pin 7106 and second pin 7108 is formed, for example, of an electrically conductive material such as a metal, and each of first pin 7106 and second pin 7108 electrically couple first substrate 7102 and second substrate 7104.

FIG. 73 illustrates in dashed lines outlines of winding ends that are connected to bottom surface 7112 of first substate 7102, where bottom surface 7112 is opposite of a top surface 7116 of first substrate. An electrical conductor 7124 of first substrate 7102 electrically couples end 6528 of first secondary winding 6514 to end 6530 of second secondary winding 6516, thereby coupling first secondary winding 6514 and second secondary winding 6516 in series. An electrical conductor electrically 7126 couples end 6526 of first secondary winding 6514 to first pin 7106, and an electrical conductor 7128 electrical couples end 6532 of second secondary winding 6516 to second pin 7108. Each of electrical conductor 7124, 7126, and 7128 includes, for example, a PCB trace or a PCB conductive polygon.

Each of first switching stage 906 and second switching stage 908 is on a bottom outer surface 7118 of second substrate 7104. First switching stage 906 is electrically coupled to end 6518 of first primary winding 6110, and second switching stage 908 is electrically coupled to end 6522 of second primary winding 6512. Capacitors 910 are located on bottom surface 7118 of second substrate 904. In certain embodiments, capacitors 910 are electrically coupled to each of end 6520 of first primary winding 6510 and end 6524 of second primary winding 6512.

In particular embodiments, magnetic device 6500, first switching stage 906, second switching stage 908, and capacitors 910 of electrical assembly 7100 form part of a multi-phase switching power converter. For example, FIG. 74 is an electrical schematic diagram of a multi-phase switching power converter 7400 at least partially formed by elements of electrical assembly 7100. It is understood, though, that electrical assembly 7100 is not limited to forming the FIG. 74 multi-phase switching power converter. Multi-phase switching power converter 7400 is similar to multi-phase switching power converter 1200 of FIG. 12 except that multi-phase switching power 7400 includes magnetic device 6500 in place of magnetic device 200. FIG. 74 illustrates tuning inductor 1204 (not shown in FIGS. 71-73) being on first substrate 7102 and controller 1206 (not shown in FIGS. 71-73) being on second substrate 7104. However, the respective locations of tuning inductor 1204 and controller 1206 in multi-phase switching power converter 7400 could vary without departing from the scope hereof.

### Combinations of Features

Features described above may be combined in various ways without departing from the scope hereof. The following examples illustrate some possible combinations.

(A1) An electrical assembly includes a first substrate, a second substrate, a magnetic device disposed between the first substrate and the second substrate, and one or more electrical conductors on the first substrate. The magnetic device includes (1) a magnetic core, (2) a first primary winding extending through the magnetic core and electrically coupling the first substrate to the second substrate, (3) a second primary winding extending through the magnetic core and electrically coupling the first substrate to the second substrate, (4) a first secondary winding wound around at least a portion of the magnetic core, opposing ends of the first secondary winding being electrically coupled to the first substrate, and (5) a second secondary winding wound around at least a portion of the magnetic core, opposing ends of the second secondary winding being electrically coupled to the first substrate. The one or more electrical conductors on the first substrate electrically couple the first secondary winding in series with the second secondary winding.

(A2) The electrical assembly denoted as (A1) may further include (1) a first switching stage on the first substrate, where the first switching stage is electrically coupled to the first primary winding, and (2) a second switching stage on the first substrate, where the second switching stage is electrically coupled to the second primary winding.

(A3) In the electrical assembly denoted as (A2), the first switching stage, the second switching stage, and the magnetic device may collectively form at least part of a multi-phase switching power converter.

(A4) The electrical assembly denoted as (A1) may further include (1) a first switching stage on the second substrate, where the first switching stage is electrically coupled to the first primary winding, and (2) a second switching stage on the second substrate, where the second switching stage is electrically coupled to the second primary winding.

(A5) In the electrical assembly denoted as (A4), the first switching stage, the second switching stage, and the magnetic device may form at least part of a multi-phase switching power converter.

(A6) In any one of the electrical assemblies denoted as (A1) through (A5), the magnetic core may form a first winding window and a second winding window, each of the first primary winding and the first secondary winding may be wound through the first winding window, and each of the second primary winding and the second secondary winding may be wound through the second winding window.

(A7) In the electrical assembly denoted as (A6), the magnetic device may be disposed between the first substrate and the second substrate in a first direction, and each of the first winding window and the second winding window may extend through the magnetic core in the first direction.

(A8) In either one of the electrical assemblies denoted as (A6) or (A7), the first winding window may be separated from the second winding window in a second direction that is orthogonal to the first direction, the first primary winding may be separated from the first secondary winding in the first winding window in the second direction, and the second primary winding may be separated from the second secondary winding in the second winding window in the second direction.

(A9) In any one of the electrical assemblies denoted as (A1) through (A8), (1) the magnetic core may form a first gap in series with a magnetic flux path in the magnetic core magnetically coupling the first primary winding and the first secondary winding, the first gap being at least partially filled with a material having a lower magnetic permeability than a magnetic material forming the magnetic core, and (2) the magnetic core may form a second gap in series with a magnetic flux path in the magnetic core magnetically coupling the second primary winding and the second secondary winding, the second gap being at least partially filled with a material having a lower magnetic permeability than the magnetic material forming the magnetic core.

(A10) In any one of the electrical assemblies denoted as (A1) through (A9), the magnetic device may further include (1) a first ground conductor electrically coupling a ground node of the first substrate to a ground node of the second substrate and (2) a second ground conductor electrically coupling the ground node of the first substrate to the ground node of the second substrate.

(A11) In the electrical assembly denoted as (A10), the first ground conductor may be wound around the first secondary winding, and the second ground conductor may be wound around the second secondary winding.

(B1) An electrical assembly includes a first substrate, a second substrate, a first magnetic device disposed between the first substrate and the second substrate, a second magnetic device disposed between the first substrate and the second substrate, and one or more electrical conductors on the first substrate. The first magnetic device includes (1) a first magnetic core, (2) a first primary winding extending through the first magnetic core and electrically coupling the first substrate to the second substrate, and (3) a first secondary winding wound around at least a portion of the first magnetic core, where opposing ends of the first secondary winding are electrically coupled to the first substrate. The second magnetic device includes (1) a second magnetic core, (2) a second primary winding extending through the second magnetic core and electrically coupling the first substrate to the second substrate, and (3) a second secondary winding wound around at least a portion of the second magnetic core, where opposing ends of the second secondary winding are electrically coupled to the first substrate. The one or more electrical conductors on the first substrate electrically couple the first secondary winding in series with the second secondary winding.

(B2) The electrical assembly denoted as (B 1) may further include (1) a first switching stage electrically coupled to the first primary winding and (2) a second switching stage electrically coupled to the second primary winding, where the first switching stage, the second switching stage, the first magnetic device, and the second magnetic device collectively form at least part of a multi-phase switching power converter.

(B3) In either one of the electrical assemblies denoted as (B1) or (B2), (1) the first magnetic core may form a first winding window, (2) each of the first primary winding and the first secondary winding may be wound through the first winding window, (3) the second magnetic core may form a second winding window, and (4) each of the second primary winding and the second secondary winding may be wound through the second winding window.

(B4) In the electrical assembly denoted as (B3), (1) each of the first magnetic device and the second magnetic device may be disposed between the first substrate and the second substrate in a first direction, (2) the first winding window may extend through the first magnetic core in the first direction, (3) the second winding window may extend through the second magnetic core in the first direction, and (4) the second magnetic device may be separated from the first magnetic device in at least one of a second direction and a third direction, the second direction being orthogonal to the first direction, and the third direction being orthogonal to each of the first direction and the second direction.

(B5) In any one of the electrical assemblies denoted as (B1) through (B4), the first magnetic device may further include a first ground conductor electrically coupling a ground node of the first substrate to a ground node of the second substrate, and the second magnetic device may further include a second ground conductor electrically coupling the ground node of the first substrate to the ground node of the second substrate.

(C1) An electrical assembly includes a common substrate, a first additional substrate, a second additional substrate, a first magnetic device disposed between the common substrate and the first additional substrate, a second magnetic device disposed between the common substrate and the second additional substrate, and one or more electrical conductors on the common substrate. The first magnetic device includes a first magnetic core, a first primary winding extending through the first magnetic core and electrically coupling the common substrate to the first additional substrate, and a first secondary winding wound around at least a portion of the first magnetic core, where opposing ends of the first secondary winding are electrically coupled to the common substrate. The second magnetic device includes a second magnetic core, a second primary winding extending through the second magnetic core and electrically coupling the common substrate to the second additional substrate, and a second secondary winding wound around at least a portion of the second magnetic core, where opposing ends of the second secondary winding are electrically coupled to the common substrate. The one or more electrical conductors on the common substrate electrically couple the first secondary winding in series with the second secondary winding.

(C2) The electrical assembly denoted as (C1) may further include (1) a first switching stage electrically coupled to the first primary winding and (2) a second switching stage electrically coupled to the second primary winding, where the first switching stage, the second switching stage, the first magnetic device, and the second magnetic device collectively form at least part of a multi-phase switching power converter.

(C3) In either one of the electrical assemblies denoted as (C1) or (C2), (1) the first magnetic core may form a first winding window, (2) each of the first primary winding and the first secondary winding may be wound through the first winding window, (3) the second magnetic core may form a second winding window, and (4) each of the second primary winding and the second secondary winding may be wound through the second winding window.

(C4) In the electrical assembly denoted as (C3), (1) the first magnetic device may be disposed between the common substrate and the first additional substrate in a first direction, (2) the second magnetic device may be disposed between the common substrate and the second additional substrate in the first direction, (3) the first winding window may extend through the first magnetic core in the first direction, (4) the second winding window may extend through the second magnetic core in the first direction, and (5) the second magnetic device may be separated from the first magnetic device in at least one of a second direction and a third direction, the second direction being orthogonal to the first direction, and the third direction being orthogonal to each of the first direction and the second direction.

(D1) An electrical assembly includes a first substrate, a second substrate, a third substrate, a magnetic device disposed between the first substrate and the second substrate in a first direction, and one or more electrical conductors on the third substrate. The magnetic device includes (1) a first primary winding extending through the magnetic core and electrically coupling the first substrate to the second substrate, (2) a second primary winding extending through the magnetic core and electrically coupling the first substrate to the second substrate, (3) a first secondary winding wound around at least a portion of the magnetic core, opposing ends of the first secondary winding being electrically coupled to the third substrate, and (4) a second secondary winding wound around at least a portion of the magnetic core, opposing ends of the second secondary winding being electrically coupled to the third substrate. The one or more electrical conductors on the third substrate electrically couple the first secondary winding in series with the second secondary winding.

(D2) In the electrical assembly denoted as (D1), the third substrate may be over each of (i) the opposing ends of the first secondary winding and (ii) the opposing ends of the second secondary winding, in a direction orthogonal to the first direction.

(D3) In either one of the electrical assemblies denoted as (D1) or (D2), (1) a first end of the first primary winding may terminate on a first outer surface of the magnetic core, (2) a first end of the second primary winding may terminate on the first outer surface of the magnetic core, (3) a second end of the first primary winding may terminate on a second outer surface of the magnetic core, the second outer surface of the magnetic core being opposite of the first outer surface of the magnetic core, (4) the opposing ends of the first secondary winding may terminate on a third outer surface of the magnetic core, the third outer surface joining the first outer surface and the second outer surface in the first direction, and (5) the opposing ends of the of the second secondary winding may terminate on the third outer surface of the magnetic core.

(D4) Any one of the electrical assemblies denoted as (D1) through (D3) may further include (1) a first switching stage electrically coupled to the first primary winding and (2) a second switching stage electrically coupled to the second primary winding, where the first switching stage, the second switching stage, and the magnetic device collectively form at least part of a multi-phase switching power converter.

(D5) In any one of the electrical assemblies denoted as (D1) through (D4), (1) the magnetic core may form a first winding window extending through the magnetic core in the first direction, (2) each of the first primary winding and the first secondary winding may be wound through the first winding window, (3) the magnetic core may form a second winding window extending through the magnetic core in the second direction, and (4) each of the second primary winding and the second secondary winding may be wound through the second winding window.

(E1) An electrical assembly includes a first substrate, a second substrate, a magnetic device disposed between the first substrate and the second substrate in a first direction, and one or more electrical conductors on the first substrate. The magnetic device includes (1) a magnetic core, (2) a first primary winding extending through the magnetic core in a second direction that is orthogonal to the first direction, where opposing ends of the first primary winding are connected to the second substrate, (3) a second primary winding extending through the magnetic core in the second direction, where opposing ends of the second primary winding are connected to the second substrate, (4) a first secondary winding extending through the magnetic core in the second direction, where opposing ends of the first secondary winding are connected to the first substrate, and (5) a second secondary winding extending through the magnetic core in the second direction, where opposing ends of the second secondary winding are connected to the first substrate. The one or more electrical conductors on the first substrate electrically couple the first secondary winding in series with the second secondary winding.

(E2) In the electrical assembly denoted as (E1), (1) the opposing ends of the first secondary winding and the opposing ends of the second secondary winding may terminate on a first outer surface of the magnetic core, and (2) the opposing ends of the first primary winding and the opposing ends of the second primary winding may terminate on a second outer surface of the magnetic core, where the second outer surface is opposite of the first outer surface.

(E3) Either one of the electrical assemblies denoted as (E1) or (E2) may further include (1) a first switching stage electrically coupled to the first primary winding and (2) a second switching stage electrically coupled to the second primary winding, where the first switching stage, the second switching stage, and the magnetic device collectively form at least part of a multi-phase switching power converter.

(E4) Any one of the electrical assemblies denoted as (E1) through (E3) may further include one or more pins disposed between the first substrate and the second substrate, where the one or more pins electrically couple the first substrate and the second substrate.

Changes may be made in the above methods, devices, and systems without departing from the scope hereof. It should thus be noted that the matter contained in the above description and shown in the accompanying drawings should be interpreted as illustrative and not in a limiting sense. The following claims are intended to cover generic and specific features described herein, as well as all statements of the scope of the present method and system, which as a matter of language, might be said to fall therebetween.

### ASPECTS OF THE DISCLOSURE

Non-limiting aspects of the disclosure are set out in the following numbered clauses.
1. An electrical assembly, comprising:
   a first substrate;
   a second substrate;
   a magnetic device disposed between the first substrate and the second substrate, the magnetic device including:
      a magnetic core,
      a first primary winding extending through the magnetic core and electrically coupling the first substrate to the second substrate,
      a second primary winding extending through the magnetic core and electrically coupling the first substrate to the second substrate,
      a first secondary winding wound around at least a portion of the magnetic core, opposing ends of the first secondary winding being electrically coupled to the first substrate, and
      a second secondary winding wound around at least a portion of the magnetic core, opposing ends of the second secondary winding being electrically coupled to the first substrate; and
   one or more electrical conductors on the first substrate electrically coupling the first secondary winding in series with the second secondary winding.
2. The electrical assembly of clause 1, further comprising:
   a first switching stage on the first substrate, the first switching stage being electrically coupled to the first primary winding; and
   a second switching stage on the first substrate, the second switching stage being electrically coupled to the second primary winding.
3. The electrical assembly of clause 2, wherein the first switching stage, the second switching stage, and the magnetic device collectively form at least part of a multi-phase switching power converter.
4. The electrical assembly of clause 1, further comprising:
   a first switching stage on the second substrate, the first switching stage being electrically coupled to the first primary winding; and
   a second switching stage on the second substrate, the second switching stage being electrically coupled to the second primary winding.
5. The electrical assembly of clause 4, wherein the first switching stage, the second switching stage, and the magnetic device form at least part of a multi-phase switching power converter.
6. The electrical assembly of any preceding clause, wherein:
   the magnetic core forms a first winding window and a second winding window;
   each of the first primary winding and the first secondary winding are wound through the first winding window; and
   each of the second primary winding and the second secondary winding are wound through the second winding window.
7. The electrical assembly of clause 6, wherein:
   the magnetic device is disposed between the first substrate and the second substrate in a first direction; and
   each of the first winding window and the second winding window extends through the magnetic core in the first direction.
8. The electrical assembly of clause 7, wherein
   the first winding window is separated from the second winding window in a second direction that is orthogonal to the first direction;
   the first primary winding is separated from the first secondary winding in the first winding window in the second direction; and
   the second primary winding is separated from the second secondary winding in the second winding window in the second direction.
9. The electrical assembly of any preceding clause, wherein:
   the magnetic core forms a first gap in series with a magnetic flux path in the magnetic core magnetically coupling the first primary winding and the first secondary winding, the first gap being at least partially filled with a material having a lower magnetic permeability than a magnetic material forming the magnetic core; and
   the magnetic core forms a second gap in series with a magnetic flux path in the magnetic core magnetically coupling the second primary winding and the second secondary winding, the second gap being at least partially filled with a material having a lower magnetic permeability than the magnetic material forming the magnetic core.
10. The electrical assembly of any preceding clause, wherein the magnetic device further includes:
   a first ground conductor electrically coupling a ground node of the first substrate to a ground node of the second substrate; and
   a second ground conductor electrically coupling the ground node of the first substrate to the ground node of the second substrate.
11. The electrical assembly of clause 10, wherein:
   the first ground conductor is wound around the first secondary winding; and
   the second ground conductor is wound around the second secondary winding.
12. An electrical assembly, comprising:
   a first substrate;
   a second substrate;
   a first magnetic device disposed between the first substrate and the second substrate, the first magnetic device including:
      a first magnetic core,
      a first primary winding extending through the first magnetic core and electrically coupling the first substrate to the second substrate, and
      a first secondary winding wound around at least a portion of the first magnetic core, opposing ends of the first secondary winding being electrically coupled to the first substrate;
   a second magnetic device disposed between the first substrate and the second substrate, the second magnetic device including:
      a second magnetic core,
      a second primary winding extending through the second magnetic core and electrically coupling the first substrate to the second substrate, and
      a second secondary winding wound around at least a portion of the second magnetic core, opposing ends of the second secondary winding being electrically coupled to the first substrate; and
   one or more electrical conductors on the first substrate electrically coupling the first secondary winding in series with the second secondary winding.
13. The electrical assembly of clause 12, further comprising:
   a first switching stage electrically coupled to the first primary winding; and
   a second switching stage electrically coupled to the second primary winding,
   wherein the first switching stage, the second switching stage, the first magnetic device, and the second magnetic device collectively form at least part of a multi-phase switching power converter.
14. The electrical assembly of clause 12 or clause 13, wherein:
   the first magnetic core forms a first winding window;
   each of the first primary winding and the first secondary winding are wound through the first winding window;
   the second magnetic core forms a second winding window; and
   each of the second primary winding and the second secondary winding are wound through the second winding window.
15. The electrical assembly of clause 14, wherein:
   each of the first magnetic device and the second magnetic device is disposed between the first substrate and the second substrate in a first direction;
   the first winding window extends through the first magnetic core in the first direction;
   the second winding window extends through the second magnetic core in the first direction; and
   the second magnetic device is separated from the first magnetic device in at least one of a second direction and a third direction, the second direction being orthogonal to the first direction, and the third direction being orthogonal to each of the first direction and the second direction.
16. The electrical assembly of any of clauses 12 to 15, wherein:
   the first magnetic device further includes a first ground conductor electrically coupling a ground node of the first substrate to a ground node of the second substrate; and
   the second magnetic device further includes a second ground conductor electrically coupling the ground node of the first substrate to the ground node of the second substrate.
17. An electrical assembly, comprising:
   a common substrate;
   a first additional substrate;
   a second additional substrate;
   a first magnetic device disposed between the common substrate and the first additional substrate, the first magnetic device including:
      a first magnetic core,
      a first primary winding extending through the first magnetic core and electrically coupling the common substrate to the first additional substrate, and
      a first secondary winding wound around at least a portion of the first magnetic core, opposing ends of the first secondary winding being electrically coupled to the common substrate;
   a second magnetic device disposed between the common substrate and the second additional substrate, the second magnetic device including:
      a second magnetic core,
      a second primary winding extending through the second magnetic core and electrically coupling the common substrate to the second additional substrate, and
      a second secondary winding wound around at least a portion of the second magnetic core, opposing ends of the second secondary winding being electrically coupled to the common substrate; and
   one or more electrical conductors on the common substrate electrically coupling the first secondary winding in series with the second secondary winding.
18. The electrical assembly of clause 17, further comprising:
   a first switching stage electrically coupled to the first primary winding; and
   a second switching stage electrically coupled to the second primary winding,
   wherein the first switching stage, the second switching stage, the first magnetic device, and the second magnetic device collectively form at least part of a multi-phase switching power converter.
19. The electrical assembly of clause 17 or clause 18, wherein:
   the first magnetic core forms a first winding window;
   each of the first primary winding and the first secondary winding are wound through the first winding window;
   the second magnetic core forms a second winding window; and
   each of the second primary winding and the second secondary winding are wound through the second winding window.
20. The electrical assembly of clause 19, wherein:
   the first magnetic device is disposed between the common substrate and the first additional substrate in a first direction;
   the second magnetic device is disposed between the common substrate and the second additional substrate in the first direction;
   the first winding window extends through the first magnetic core in the first direction;
   the second winding window extends through the second magnetic core in the first direction; and
   the second magnetic device is separated from the first magnetic device in at least one of a second direction and a third direction, the second direction being orthogonal to the first direction, and the third direction being orthogonal to each of the first direction and the second direction.

## Claims

1. An electrical assembly, comprising:
a first substrate;
a second substrate;
a magnetic device disposed between the first substrate and the second substrate, the magnetic device including:
a magnetic core,
a first primary winding extending through the magnetic core and electrically coupling the first substrate to the second substrate,
a second primary winding extending through the magnetic core and electrically coupling the first substrate to the second substrate,
a first secondary winding wound around at least a portion of the magnetic core, opposing ends of the first secondary winding being electrically coupled to the first substrate, and
a second secondary winding wound around at least a portion of the magnetic core, opposing ends of the second secondary winding being electrically coupled to the first substrate; and
one or more electrical conductors on the first substrate electrically coupling the first secondary winding in series with the second secondary winding.

2. The electrical assembly of claim 1, further comprising:
a first switching stage on the first substrate, the first switching stage being electrically coupled to the first primary winding; and
a second switching stage on the first substrate, the second switching stage being electrically coupled to the second primary winding.

3. The electrical assembly of claim 2, wherein the first switching stage, the second switching stage, and the magnetic device collectively form at least part of a multi-phase switching power converter.

4. The electrical assembly of claim 1, further comprising:
a first switching stage on the second substrate, the first switching stage being electrically coupled to the first primary winding; and
a second switching stage on the second substrate, the second switching stage being electrically coupled to the second primary winding.

5. The electrical assembly of claim 4, wherein the first switching stage, the second switching stage, and the magnetic device form at least part of a multi-phase switching power converter.

6. The electrical assembly of any preceding claim, wherein:
the magnetic core forms a first winding window and a second winding window;
each of the first primary winding and the first secondary winding are wound through the first winding window; and
each of the second primary winding and the second secondary winding are wound through the second winding window.

7. The electrical assembly of claim 6, wherein:
the magnetic device is disposed between the first substrate and the second substrate in a first direction; and
each of the first winding window and the second winding window extends through the magnetic core in the first direction.

8. The electrical assembly of claim 7, wherein
the first winding window is separated from the second winding window in a second direction that is orthogonal to the first direction;
the first primary winding is separated from the first secondary winding in the first winding window in the second direction; and
the second primary winding is separated from the second secondary winding in the second winding window in the second direction.

9. The electrical assembly of any preceding claim, wherein:
the magnetic core forms a first gap in series with a magnetic flux path in the magnetic core magnetically coupling the first primary winding and the first secondary winding, the first gap being at least partially filled with a material having a lower magnetic permeability than a magnetic material forming the magnetic core; and
the magnetic core forms a second gap in series with a magnetic flux path in the magnetic core magnetically coupling the second primary winding and the second secondary winding, the second gap being at least partially filled with a material having a lower magnetic permeability than the magnetic material forming the magnetic core.

10. The electrical assembly of any preceding claim, wherein the magnetic device further includes:
a first ground conductor electrically coupling a ground node of the first substrate to a ground node of the second substrate; and
a second ground conductor electrically coupling the ground node of the first substrate to the ground node of the second substrate.

11. The electrical assembly of claim 10, wherein:
the first ground conductor is wound around the first secondary winding; and
the second ground conductor is wound around the second secondary winding.

12. An electrical assembly, comprising:
a first substrate;
a second substrate;
a first magnetic device disposed between the first substrate and the second substrate, the first magnetic device including:
a first magnetic core,
a first primary winding extending through the first magnetic core and electrically coupling the first substrate to the second substrate, and
a first secondary winding wound around at least a portion of the first magnetic core, opposing ends of the first secondary winding being electrically coupled to the first substrate;
a second magnetic device disposed between the first substrate and the second substrate, the second magnetic device including:
a second magnetic core,
a second primary winding extending through the second magnetic core and electrically coupling the first substrate to the second substrate, and
a second secondary winding wound around at least a portion of the second magnetic core, opposing ends of the second secondary winding being electrically coupled to the first substrate; and
one or more electrical conductors on the first substrate electrically coupling the first secondary winding in series with the second secondary winding.

13. The electrical assembly of claim 12, further comprising:
a first switching stage electrically coupled to the first primary winding; and
a second switching stage electrically coupled to the second primary winding,
wherein the first switching stage, the second switching stage, the first magnetic device, and the second magnetic device collectively form at least part of a multi-phase switching power converter.

14. An electrical assembly, comprising:
a common substrate;
a first additional substrate;
a second additional substrate;
a first magnetic device disposed between the common substrate and the first additional substrate, the first magnetic device including:
a first magnetic core,
a first primary winding extending through the first magnetic core and electrically coupling the common substrate to the first additional substrate, and
a first secondary winding wound around at least a portion of the first magnetic core, opposing ends of the first secondary winding being electrically coupled to the common substrate;
a second magnetic device disposed between the common substrate and the second additional substrate, the second magnetic device including:
a second magnetic core,
a second primary winding extending through the second magnetic core and electrically coupling the common substrate to the second additional substrate, and
a second secondary winding wound around at least a portion of the second magnetic core, opposing ends of the second secondary winding being electrically coupled to the common substrate; and
one or more electrical conductors on the common substrate electrically coupling the first secondary winding in series with the second secondary winding.

15. The electrical assembly of claim 14, further comprising:
a first switching stage electrically coupled to the first primary winding; and
a second switching stage electrically coupled to the second primary winding,
wherein the first switching stage, the second switching stage, the first magnetic device, and the second magnetic device collectively form at least part of a multi-phase switching power converter.
